(19) Europäisches Patentamt
European Patent Office
Office européen des brevets

(11) EP 4 091 811 A1

(12) EUROPEAN PATENT APPLICATION
published in accordance with Art. 153(4) EPC

(43) Date of publication:
**23.11.2022 Bulletin 2022/47**

(21) Application number: **21741219.6**

(22) Date of filing: **06.01.2021**

(51) International Patent Classification (IPC):
***B32B 15/08*** *(2006.01)* ***B32B 15/092*** *(2006.01)*
***H05K 1/03*** *(2006.01)*

(52) Cooperative Patent Classification (CPC):
**B32B 15/08; B32B 15/092; H05K 1/03**

(86) International application number:
**PCT/JP2021/000147**

(87) International publication number:
**WO 2021/145240 (22.07.2021 Gazette 2021/29)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **16.01.2020 JP 2020005401**

(71) Applicant: **Sumitomo Seika Chemicals Co., Ltd.**
**Kako-gun, Hyogo 675-0145 (JP)**

(72) Inventor: **HARISAKI, Ryota**
**Kako-gun, Hyogo 675-0145 (JP)**

(74) Representative: **Vossius & Partner**
**Patentanwälte Rechtsanwälte mbB**
**Siebertstraße 3**
**81675 München (DE)**

# (54) LAMINATED BODY HAVING COPPER FOIL AND EPOXY RESIN COMPOSITION LAYER

(57) Provided is copper foil with a resin layer, the resin layer having excellent adhesion, the copper foil exhibiting low dielectric characteristics, which is suitable for high-frequency applications, the copper foil being capable of exhibiting excellent transmission loss characteristics, i.e., exhibiting excellent characteristics of reducing transmission loss. More specifically, the present invention provides a laminate comprising copper foil and an epoxy resin composition layer, the epoxy resin composition layer being present on at least one surface of the copper foil, the epoxy resin composition containing an epoxy resin and an acid-modified polyolefin, wherein a test piece composed of the laminate and a prepreg has 90-degree peel strength between the copper foil and the prepreg of 0.6 N/mm or more as measured in accordance with JISC6481, and has a reduction rate of the 90-degree peel strength between the copper foil and the prepreg of 20% or less after immersion of the test piece in boiling water for 2 hours.

EP 4 091 811 A1

## Description

### Technical Field

The present disclosure relates to, for example, a laminate comprising copper foil and an epoxy resin composition layer. The present disclosure also relates to, for example, a copper-clad laminated sheet and a printed circuit board, each comprising the laminate.

### Background Art

Known copper foil for use in the production of copper-clad laminated sheets and printed circuit boards includes copper foil with a resin layer, in which the resin layer is present on one surface of the copper foil for the purpose of improving adhesion to resin substrates, such as a prepreg. Prepreg is a generic term for composite materials obtained by impregnating a synthetic resin into substrates, such as synthetic resin plates, glass plates, glass woven fabric, glass non-woven fabric, and paper.

For example, Patent Literature (PTL) 1 discloses copper foil with a resin layer. This copper foil comprises a resin layer containing filler particles on one surface of the copper foil. PTL 1 discloses that the resin layer containing filler particles comprises an aromatic polyamide resin polymer, an epoxy resin, and a curing accelerator, and is a semi-cured resin layer containing filler particles treated with phenylaminosilane, which is an amino silane coupling agent.

Further, for example, PTL 2 discloses a copper foil with an adhesive layer. This copper foil comprises the resin layer on one surface of the copper foil. PTL 2 discloses that the adhesive layer comprises a resin composition containing a styrene-butadiene block copolymer in an amount of 5 parts by mass or more and 65 parts by mass or less per 100 parts by mass of a polyphenylene ether compound.

Further, for example, PTL 3 discloses a copper foil with an adhesive layer. This copper foil comprises the resin layer on one surface of the copper foil. PTL 3 discloses that the adhesive layer comprises a resin mixture containing an epoxy resin, a polyimide resin, and an aromatic polyamide resin.

Printed circuit boards have made significant progress over the last half century and have been used in a wide variety of electronic devices. With the recent increasing need for smaller electrical devices and higher performance, progress has been made in terms of higher-density mounting of mounted components and higher-frequency signals, and printed circuit boards are required to address higher frequencies in an excellent manner.

### Citation List

#### Patent Literature

PTL 1: JP5118469B
PTL 2: JP6215711B
PTL 3: JP6426290B

### Summary of Invention

#### Technical Problem

Transmission loss of signal wiring on a printed circuit board etc. is deemed to be due to the conductor loss (copper foil side) caused according to the conductor shape, skin resistance, characteristic impedance, etc., and due to dielectric loss (resin side) caused according to dielectric characteristics etc. of the insulating layer around the wiring. At low frequencies, the former (conductor loss) is dominant; at about 3 GHz, the former and the latter are about the same; and at high frequencies, the latter (dielectric loss) is dominant. Printed circuit boards that address high frequencies are greatly affected by dielectric loss. Since the dielectric loss increases in proportion to the product of the square root of the relative dielectric constant of the material and the dielectric loss tangent of the material, materials having both low relative dielectric constant and low dielectric loss tangent are required.

To achieve the above requirements, it is desired that the resin layer has excellent dielectric characteristics. In particular, it is desired that the resin layer has a low dielectric loss tangent. However, although the copper foil with a resin layer such as those disclosed in, for example, PTL 1, PTL, 2, and PTL 3 can improve adhesion to prepregs and other resin substrates, they are unsuitable for high-frequency applications since their dielectric loss tangent is high, and the transmission loss thus has a tendency to become higher.

Accordingly, copper foil with a resin layer, the resin layer having excellent adhesion, the copper foil exhibiting low dielectric characteristics, which is suitable for high-frequency applications, the copper foil being capable of exhibiting excellent transmission loss characteristics, i.e., capable of exhibiting excellent characteristics of reducing transmission loss, is in demand.

Solution to Problem

As a result of extensive research, the present inventor found that when a laminate is obtained by forming an epoxy resin composition layer having a specific formulation on at least one surface of copper foil (which can also be referred to as "copper foil with an epoxy resin composition layer"), the epoxy resin composition has excellent adhesion, and the laminate achieves reduced transmission loss. The inventor then conducted further research.
The present disclosure encompasses, for example, the subject matter described in the following items.

Item 1.

A laminate comprising copper foil and an epoxy resin composition layer,

the epoxy resin composition layer being present on at least one surface of the copper foil, the epoxy resin composition layer containing an epoxy resin composition,
the epoxy resin composition containing an epoxy resin and an acid-modified polyolefin,

wherein a test piece composed of the laminate and a prepreg has 90-degree peel strength between the laminate and the prepreg of 0.6 N/mm or more as measured in accordance with JISC6481, and has a reduction rate of the 90-degree peel strength between the laminate and the prepreg of 20% or less after immersion of the test piece in boiling water for 2 hours.

Item 2.

The laminate according to Item 1,

wherein $X - Y \geq 0.5$,
with the transmission loss at 40 GHz of a circuit substrate having a characteristic impedance of 50 $\Omega$ and a line length of 100 mm taken as XdB/100 mm, the circuit substrate comprising the laminate and a resin substrate having a dielectric loss tangent at a frequency of 1 GHz at 25°C of 0.016, such that the epoxy resin composition layer of the laminate is in contact with the resin substrate, and
with the transmission loss at 40 GHz of a circuit substrate taken as YdB/100 mm, the circuit substrate comprising the copper foil and the resin substrate such that the copper foil is in contact with the resin substrate.

Item 3.

The laminate according to Item 1 or 2,
wherein the epoxy resin is an epoxy resin whose cured product has a dielectric loss tangent at a frequency of 10 GHz at 25°C of 0.015 or less and relative dielectric constant at a frequency of 10 GHz at 25°C of 2.8 or less.

Item 4a.

The laminate according to any one of Items 1 to 3,
wherein the epoxy resin is one or more members selected from the group consisting of bisphenol A epoxy resins, biphenyl epoxy resins, dicyclopentadiene epoxy resins, anthracene epoxy resins, and silicon element-containing epoxy resins.

Item 4b.

The laminate according to any one of Items 1 to 3,
wherein the epoxy resin is at least one epoxy resin selected from the group consisting of
an epoxy resin represented by formula (1-iia):

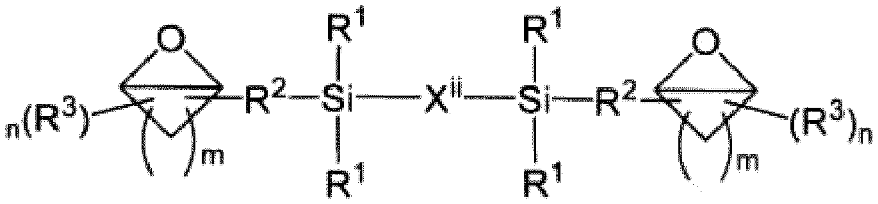

(1-iia)

wherein $X^{ii}$ is a divalent group obtained by removing two hydrogen atoms from a saturated hydrocarbon ring or an unsaturated hydrocarbon ring, or from rings having a structure in which 2 to 6 saturated hydrocarbon rings and/or unsaturated hydrocarbon rings are condensed; or a divalent group represented by formula ($2^g$-iia) :

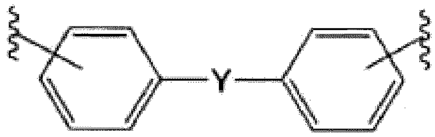

($2^g$-iia)

wherein Y is a bond, a $C_{1-6}$ alkylene group that may be substituted with a $C_{1-4}$ alkyl group, an oxygen atom (-O-), a sulfur atom (-S-), -SO-, or $-SO_2-$;

$R^1$ is the same or different, and is a $C_{1-18}$ alkyl group, a $C_{2-9}$ alkenyl group, a cycloalkyl group, an aryl group, or an aralkyl group, wherein one or more carbon atoms of these groups may be replaced by at least one atom selected from the group consisting of an oxygen atom and a nitrogen atom;
$R^2$ is the same or different, and is a $C_{1-18}$ alkylene group, wherein one or more carbon atoms of this group other than a carbon atom directly bonded to a silicon atom may be replaced by at least one atom selected from the group consisting of an oxygen atom and a nitrogen atom;
$R^3$ is the same or different, and is a $C_{1-18}$ alkyl group, a $C_{2-9}$ alkenyl group, a cycloalkyl group, an aryl group, or an aralkyl group, wherein one or more carbon atoms of these groups may be replaced by at least one atom selected from the group consisting of an oxygen atom and a nitrogen atom;
m is an integer of 0 to 6; and
n is an integer of 0 to 3;

an epoxy resin represented by formula (1-iiia):

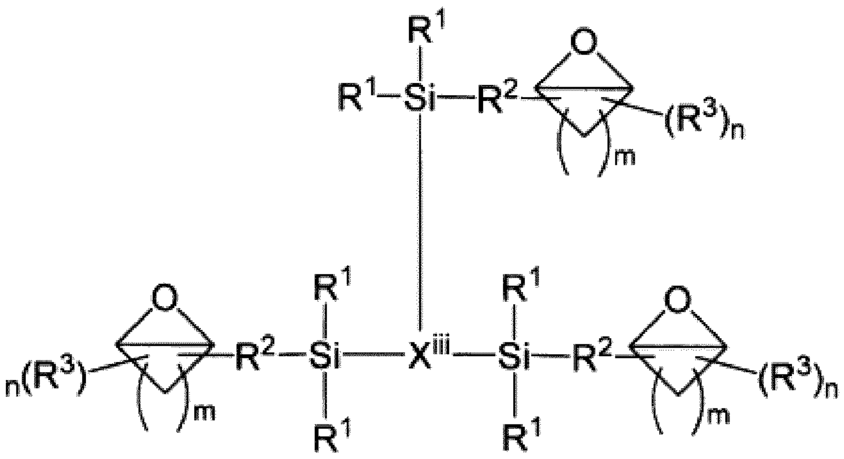

(1-iiia)

wherein $X^{iii}$ is a trivalent group obtained by removing three hydrogen atoms from a saturated hydrocarbon ring or an unsaturated hydrocarbon ring, or from rings having a structure in which 2 to 6 saturated hydrocarbon rings and/or unsaturated hydrocarbon rings are condensed; or a trivalent group represented by formula ($2^g$-iiia):

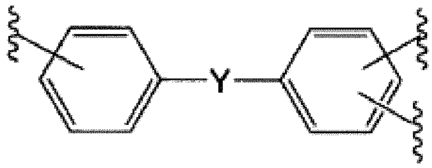

(2g-iiia)

wherein Y is as defined above; and
$R^1$, $R^2$, $R^3$, m, and n are as defined above; and an epoxy resin represented by formula (1-iva):

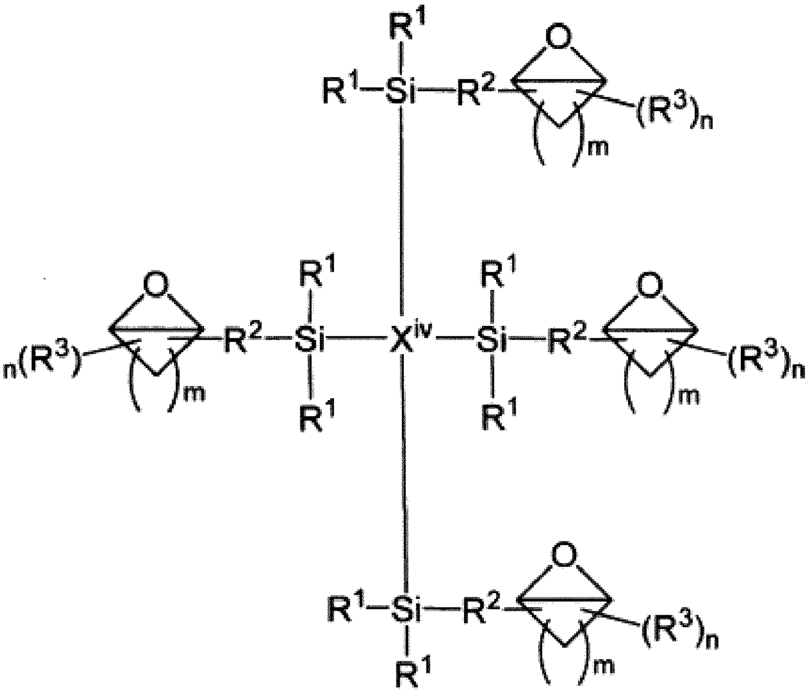

(1-iva)

wherein $X^{iv}$ is a tetravalent group obtained by removing four hydrogen atoms from a saturated hydrocarbon ring or an unsaturated hydrocarbon ring, or from rings having a structure in which 2 to 6 saturated hydrocarbon rings and/or unsaturated hydrocarbon rings are condensed; or a tetravalent group represented by formula ($2^g$):

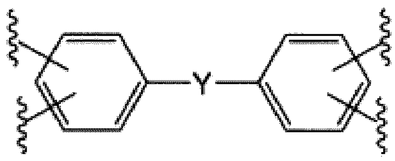

(2g)

wherein Y is as defined above; and
$R^1$, $R^2$, $R^3$, m, and n are as defined above.

Item 5.

The laminate according to any one of Items 1 to 4b,
wherein the copper foil has a surface roughness Rzjis of 1.2 μm or less on a surface in contact with the epoxy resin composition layer.

Item 6.

The laminate according to any one of Items 1 to 5,
wherein the epoxy resin composition contains the epoxy resin in an amount of 30 to 120 parts by mass per 100 parts

by mass of the acid-modified polyolefin.

Item 7.

The laminate according to any one of Items 1 to 6, wherein the epoxy resin composition further contains a curing agent.

Item 8.

The laminate according to Item 7, wherein the curing agent is at least one member selected from the group consisting of acid anhydride-based curing agents, benzoxazine-based curing agents, and active ester-based curing agents.

Item 9.

The laminate according to any one of Items 1 to 8, wherein the epoxy resin composition contains the epoxy resin and the curing agent in a total amount of 25 to 75 mass% based on the epoxy resin composition.

Item 10.

A laminate comprising copper foil and an epoxy resin composition layer,

the epoxy resin composition layer being present on at least one surface of the copper foil,
the epoxy resin composition containing an epoxy resin, an acid-modified polyolefin, and a curing agent,
the epoxy resin composition containing the epoxy resin in an amount of 30 to 120 parts by mass per 100 parts by mass of the acid-modified polyolefin, and containing the epoxy resin and the curing agent in a total amount of 25 to 75 mass% based on the epoxy resin composition.

Item 11.

A laminated product comprising the laminate of any one of Items 1 to 10, wherein the epoxy resin composition is a cured product, and the laminated product is a copper-clad laminated sheet or a printed circuit board.

Advantageous Effects of Invention

Provided is a laminate comprising copper foil and an epoxy resin composition layer, wherein the transmission loss is reduced, and the epoxy resin composition has excellent adhesion. The laminate can be used preferably for, for example, copper-clad laminated sheets and printed circuit boards.

Description of Embodiments

Each embodiment encompassed by the present disclosure is described in more detail below. The present disclosure preferably encompasses a laminate comprising copper foil and an epoxy resin composition layer, and a laminated product etc. comprising the laminate (e.g., a copper-clad laminated sheet and a printed circuit board). However, the present disclosure is not limited thereto and includes everything disclosed in the present specification and recognizable to those skilled in the art.

The laminate encompassed by the present disclosure comprises copper foil and an epoxy resin composition layer having a specific formulation, as described above. In the laminate, at least one surface of the copper foil is in contact with the epoxy resin composition layer. The laminate can also be referred to as "the copper foil with an epoxy resin composition layer." The laminate encompassed by the present disclosure may be referred to below as "the laminate of the present disclosure."

The copper foil is not particularly limited as long as the above effect is achieved when the copper foil is used for the laminate of the present disclosure. For example, the copper foil preferably has a surface roughness Rzjis of 1.2 μm or less on the surface on the epoxy resin composition layer side.

Rzjis refers to a "ten-point average roughness" measured in accordance with JISB0601. Rzjis can be measured with a contact-type surface roughness measuring instrument (SE1700, produced by Kosaka Laboratory Ltd.). The surface roughness Rzjis of the copper foil on the surface on the epoxy resin composition layer side is preferably 1.1 or 1.0 μm

or less, and more preferably 0.9 or 0.8 μm or less. Within this range, the transmission loss in high-frequency applications can be desirably reduced. Specifically, a further reduction of the transmission loss can be achieved by reducing the conductor loss caused by the copper foil; the conductor loss can increase due to the skin effect of the copper foil; the skin effect is more pronounced at higher frequencies. The lower limit of the ten-point average roughness Rzjis of the copper foil on the surface on the resin layer side is not particularly limited, and is preferably 0.005 μm or more, and more preferably 0.01 μm or more from the viewpoint of improving adhesion to the resin layer.

The thickness of the copper foil may be, for example, 0.1 to 100 μm, about 0.15 to 50 μm, or about 0.2 to 40 μm. The thickness is preferably within this range so that a modified semi-additive process (MSAP), a semi-additive process (SAP), a subtractive process, etc., which are typical patterning methods for forming wiring on a printed circuit board, can be used.

The copper foil is not particularly limited and may be, for example, metal foil (electrolytically produced foil as is or rolled foil as is), i.e., raw foil, or may be a surface-treated foil with at least one surface being treated. The surface treatment may be selected from a variety of surface treatments that are performed on the surface of metal foil for the purpose of improving or imparting some property (e.g., rust resistance, moisture resistance, chemical resistance, acid resistance, heat resistance, and adhesion to substrates). The surface treatment may be performed on at least one surface of the metal foil or on both surfaces of the metal foil. Examples of surface treatments performed on the copper foil include anti-corrosion treatment, silane treatment, roughening treatment, barrier formation treatment, and the like.

The epoxy resin composition contains an epoxy resin and an acid-modified polyolefin. The epoxy resin is preferably contained in an amount of more than 25 parts by mass and less than 125 parts by mass, and more preferably 26 to 124 parts by mass, per 100 parts by mass of the acid-modified polyolefin. The upper or lower limit of this range may be, for example, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, 100, 101, 102, 103, 104, 105, 106, 107, 108, 109, 110, 111, 112, 113, 114, 115, 116, 117, 118, 119, 120, 121, 122, or 123 parts by mass. For example, the epoxy resin is more preferably contained in an amount of 30 to 120 parts by mass per 100 parts by mass of the acid-modified polyolefin.

The thickness of the epoxy resin composition layer is preferably, for example, 0.1 to 100 μm, more preferably 0.5 to 70 μm, and still more preferably 1.0 to 50 μm.

The resin layer of the copper foil with a resin layer of the present invention is preferably composed of a thermosetting resin composition that can achieve a fully cured product (C-stage) state after curing treatment through a semi-cured (B-stage) state. The tensile elastic modulus at 25°C of the cured product of the resin layer is preferably 1.5 MPa or more, and more preferably 2.0 MPa or more, from the viewpoint of reducing warping of the substrate. On the other hand, from the viewpoint of stress relaxation and excellent adhesion to the components of a circuit layer etc., it is preferably 20 MPa or less, and more preferably 15 MPa or less.

As described above, in the laminate of the present disclosure, the epoxy resin composition layer containing an epoxy resin composition is present on at least one surface of the copper foil. In other words, in the laminate of the present disclosure, the epoxy resin composition is present on one surface or both surfaces of the copper foil. When the epoxy resin composition is present on both surfaces, each epoxy resin composition may be of a different formulation or of the same formulation. The thickness of each epoxy resin composition layer may also be the same or different.

For example, in the laminate comprising the laminate of the present disclosure and a substrate (for example, a resin substrate, more specifically, for example, a prepreg), the epoxy resin composition layer can act as a primer layer (in particular, an adhesive layer) for bonding between the copper foil of the present disclosure and the substrate. More specifically, the epoxy resin composition layer can be used for bonding between the copper foil and a substrate. Thus, the present disclosure also encompasses a laminate (laminated product) comprising a substrate (for example, a resin substrate, more specifically, for example, a prepreg) on the epoxy resin composition layer of the laminate of the present disclosure. Examples of such laminated products include copper-clad laminated sheets and printed circuit boards.

The epoxy resin composition layer may be in a semi-cured state or cured state. For example, when the laminate of the present disclosure is bonded to a substrate, the epoxy resin composition layer may be provided as a resin composition layer in a semi-cured (B-stage) state. In this case, the epoxy resin composition layer is subjected to bonding and curing by hot pressing in a subsequent step. The hot pressing may be, for example, vacuum hot pressing in which air is vacuumed in advance, and curing is then performed at a temperature of 150 to 300°C with a temperature holding time of 30 to 300 minutes and at a pressure of 10 to 60 N/cm$^2$. Furthermore, the epoxy resin composition layer may itself constitute an insulating layer in a copper-clad laminated sheet or a printed circuit board.

Examples of epoxy resins include compounds having two or more (preferably two, three, or four) epoxy groups per molecule. The epoxy resins are preferably those that are known to be usable for electrical and electronic materials. Specific examples include bisphenol A epoxy resins, bisphenol F epoxy resins, bisphenol S epoxy resins, phenol novolak epoxy resins, cresol novolak epoxy resins, cycloaliphatic epoxy resins, nitrogen ring-containing epoxy resins (e.g., triglycidyl isocyanurate), hydantoin epoxy resins, aliphatic epoxy resins, glycidyl ether epoxy resins, biphenyl epoxy resins, dicyclopentadiene epoxy resins, naphthalene epoxy resins, anthracene epoxy resin, special epoxy resins (e.g.,

silicon element-containing epoxy resins), and the like. These resins may be halogenated or hydrogenated.

Preferred are bisphenol A epoxy resins, biphenyl epoxy resins, dicyclopentadiene epoxy resins, anthracene epoxy resins, and silicon element-containing epoxy resins from the viewpoint of improving dielectric characteristics (in particular, reducing the dielectric loss tangent) of the cured product. More preferred are silicon element-containing epoxy resins represented by the following formula (1). The epoxy resins may be used alone or in a combination of two or more.

Specific examples of bisphenol A epoxy resins include jER828 and jER828EL (both produced by Mitsubishi Chemical Corporation), EPICLON840 and EPICLON860 (both produced by DIC Corporation), and the like. Specific examples of biphenyl epoxy resins include YX4000 and YL6677 (both produced by Mitsubishi Chemical Corporation), NC-3000 and NC-3000-H (both produced by Nippon Kayaku Co., Ltd.), and the like. Specific examples of dicyclopentadiene epoxy resins include HP-7200, HP-7200L, and HP-7200H (all produced by DIC Corporation), ND-1000 (produced by Nippon Kayaku Co., Ltd.), and the like. Specific examples of anthracene epoxy resins include YX8800 (produced by Mitsubishi Chemical Corporation) and the like. Specific examples of silicon element-containing epoxy resins include epoxy resins represented by formula (1) and the like.

Examples of epoxy resins that can be preferably used in the epoxy resin composition of the present disclosure include epoxy resins represented by formula (1):

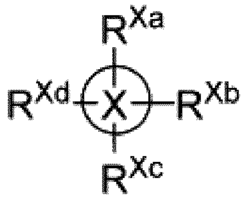

(1)

In formula (1), $R^{Xa}$, $R^{Xb}$, $R^{Xc}$, and $R^{Xd}$ are the same or different, and each is a hydrogen atom, a lower alkyl group, a lower alkoxy group, a lower alkenyl group, a halogen atom, or a group represented by formula (3):

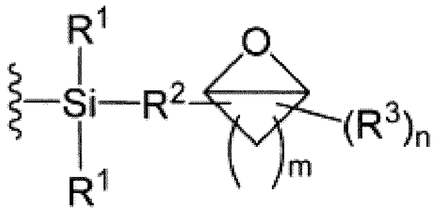

(3)

(hereinafter also referred to as the "group of formula (3)"). Hereinafter, a lower alkyl group, a lower alkoxy group, and a lower alkenyl group are also collectively referred to as "lower carbon substituents." In the present disclosure, among the lower carbon substituents, a lower alkyl group or a lower alkoxy group is more preferable.

However, at least one of $R^{Xa}$, $R^{Xb}$, $R^{Xc}$, and $R^{Xd}$ is a group of formula (3). In other words, three of $R^{Xa}$, $R^{Xb}$, $R^{Xc}$, and $R^{Xd}$ are hydrogen atoms, halogen atoms, or lower carbon substituents, and the other one is a group of formula (3); two of them are hydrogen atoms, halogen atoms, or lower carbon substituents, and the other two are groups of formula (3); one of them is a hydrogen atom, a halogen atom, or a lower carbon substituent, and the other three are groups of formula (3); or all of them are groups of formula (3). More specifically, for example, $R^{Xa}$, $R^{Xb}$, $R^{Xc}$, and $R^{Xd}$ may be as follows:

(i) $R^{Xa}$, $R^{Xb}$, and $R^{Xc}$ are hydrogen atoms, halogen atoms, or lower carbon substituents, and $R^{Xd}$ is a group of formula (3);
(ii) $R^{Xa}$ and $R^{Xb}$ are hydrogen atoms, halogen atoms, or lower carbon substituents, and $R^{Xc}$ and $R^{Xd}$ are groups of formula (3) ;
(iii) $R^{Xa}$ is a hydrogen atom, a halogen atom, or a lower carbon substituent, and $R^{Xb}$, $R^{Xc}$, and $R^{Xd}$ are groups of formula (3); or
(iv) all of $R^{Xa}$, $R^{Xb}$, $R^{Xc}$, and $R^{Xd}$ are groups of formula (3) .

Of $R^{Xa}$, $R^{Xb}$, $R^{Xc}$, and $R^{Xd}$, one or more members that are not groups of formula (3) are more preferably hydrogen atoms or lower carbon substituents.

In formula (1), $R^{Xa}$, $R^{Xb}$, $R^{Xc}$, and $R^{Xd}$ may be the same or different. Therefore, (i) when $R^{Xa}$, $R^{Xb}$, and $R^{Xc}$ are hydrogen atoms, halogen atoms, or lower carbon substituents, and when $R^{Xd}$ is a group of formula (3), $R^{Xa}$, $R^{Xb}$, and $R^{Xc}$ may be the same or different. (ii) When $R^{Xa}$ and $R^{Xb}$ are hydrogen atoms, halogen atoms, or lower carbon substituents,

and when $R^{Xc}$ and $R^{Xd}$ are groups of formula (3), $R^{Xa}$ and $R^{Xb}$ may be the same or different, and $R^{Xc}$ and $R^{Xd}$ may also be the same or different. (iii) When $R^{Xa}$ is a hydrogen atom, a halogen atom, or a lower carbon substituent, and when $R^{Xb}$, $R^{Xc}$, and $R^{Xd}$ are groups of formula (3), $R^{Xb}$, $R^{Xc}$, and $R^{Xd}$ may be the same or different. (iv) When all of $R^{Xa}$, $R^{Xb}$, $R^{Xc}$, and $R^{Xd}$ are groups of formula (3), $R^{Xa}$, $R^{Xb}$, $R^{Xc}$, and $R^{Xd}$ may be the same or different. In any of these cases, the groups of formula (3) are preferably the same.

Moreover, when two or three of $R^{Xa}$, $R^{Xb}$, $R^{Xc}$, and $R^{Xd}$ are halogen atoms or lower carbon substituents, these halogen atoms or lower carbon substituents may also be the same or different. In this case, two or three of $R^{Xa}$, $R^{Xb}$, $R^{Xc}$, and $R^{Xd}$ are more preferably the same lower carbon substituents.

In the present specification, the lower carbon substituent refers to a lower alkyl group, a lower alkoxy group, or a lower alkenyl group. The term "lower" used herein means 1 to 6 (1, 2, 3, 4, 5, or 6) carbon atoms. Of the lower carbon substituents, a lower alkyl group or a lower alkoxy group is preferable. Specifically, preferable examples of lower alkyl groups include a methyl group, an ethyl group, an n-propyl group, an isopropyl group, an n-butyl group, an isobutyl group, and the like. Preferable examples of lower alkoxy groups include a methoxy group, an ethoxy group, a propoxy group, an isopropoxy group, a butoxy group, an isobutoxy group, and the like.

Moreover, in the present specification, the halogen atom is a fluorine atom, a chlorine atom, a bromine atom, or an iodine atom; preferably a fluorine atom, a chlorine atom, or a bromine atom; and more preferably a fluorine atom or a bromine atom.

In formula (1), X ring is a saturated hydrocarbon ring or an unsaturated hydrocarbon ring, or rings having a structure in which 2 to 6 saturated hydrocarbon rings and/or unsaturated hydrocarbon rings are condensed, or in which 2 saturated hydrocarbon rings and/or unsaturated hydrocarbon rings are connected. In the present specification, the saturated hydrocarbon ring is, for example, preferably a $C_{4-8}$ (4, 5, 6, 7, or 8) saturated hydrocarbon ring, and particularly preferably a cyclopentane ring, a cyclohexane ring, or the like. In the present specification, the unsaturated hydrocarbon ring is, for example, preferably a $C_{4-8}$ (4, 5, 6, 7, or 8) unsaturated hydrocarbon ring, and particularly preferably a benzene ring or the like. In the present specification, the rings having a structure in which 2 to 6 saturated hydrocarbon rings and/or unsaturated hydrocarbon rings are condensed are preferably 2, 3, or 4 condensed saturated hydrocarbon rings and/or unsaturated hydrocarbon rings, and more preferably 2 or 3 condensed saturated hydrocarbon rings and/or unsaturated hydrocarbon rings. More specific examples include a decahydronaphthalene ring, an adamantane ring, a naphthalene ring, a phenanthrene ring, an anthracene ring, a pyrene ring, a triphenylene ring, a tetralin ring, 1,2,3,4,5,6,7,8-octahydronaphthalene ring, a norbornene ring, and the like.

In the present specification, a saturated hydrocarbon ring or an unsaturated hydrocarbon ring, or rings having a structure in which 2 to 6 saturated hydrocarbon rings and/or unsaturated hydrocarbon rings are condensed, are also collectively referred to as "hydrocarbon rings."

The rings having a structure in which 2 saturated hydrocarbon rings and/or unsaturated hydrocarbon rings are connected are preferably rings represented by formula (2):

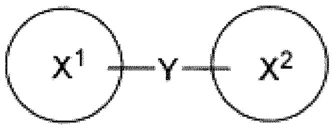

(2)

In formula (2), $X^1$ ring and $X^2$ ring are the same or different, and each is a saturated hydrocarbon ring or an unsaturated hydrocarbon ring. That is, the $X^1$ ring and $X^2$ ring are both saturated hydrocarbon rings or unsaturated hydrocarbon rings; or one of them is a saturated hydrocarbon ring, and the other is an unsaturated hydrocarbon ring. It is preferable that the $X^1$ ring and the $X^2$ ring both be saturated hydrocarbon rings or unsaturated hydrocarbon rings. For example, it is preferable that the $X^1$ ring and the $X^2$ ring both be benzene rings or cyclohexane rings, or that one of them be a benzene ring and the other be a cyclohexane ring; and it is more preferable that both of them be benzene rings.

Moreover, Y is a bond, a $C_{1-6}$ alkylene group that may be substituted with a $C_{1-4}$ alkyl group, an oxygen atom (-O-), a sulfur atom (-S-), -SO-, or $-SO_2-$. Examples of the $C_{1-6}$ alkylene group include a methylene group, an ethylene group, a trimethylene group, a tetramethylene group, a hexamethylene group, and the like. Moreover, examples of the $C_{1-4}$ alkyl group as a substituent include a methyl group, an ethyl group, an n-propyl group, an isopropyl group, an n-butyl group, an isobutyl group, and the like. Preferable examples of the $C_{1-6}$ alkylene group substituted with a $C_{1-4}$ alkyl group include $-CH(CH_3)-$, $-C(CH_3)_2-$, $-CH_2CH(CH_3)CH_2-$, $-CH_2C(CH_3)_2CH_2-$, and the like. Y is preferably a bond, an oxygen atom, a methylene group, a dimethylmethylene group, -S-, or $-SO_2-$; and more preferably a bond, a dimethylmethylene group, an oxygen atom, or $-SO_2-$.

The rings represented by formula (2) are substituted with $R^{Xa}$, $R^{Xb}$, $R^{Xc}$, and $R^{Xd}$. When the X ring of formula (1) is rings represented by formula (2), when three of $R^{Xa}$ to $R^{Xd}$ are hydrogen atoms, halogen atoms, or lower carbon substituents, and when the other one is a group of formula (3), one of the $X^1$ ring and $X^2$ ring may be substituted with a

group of formula (3). In this case, the rings represented by formula (2) are substituted with 0, 1, 2, or 3 halogen atoms or lower carbon substituents, and (number of halogen atoms or lower carbon substituents substituted in $X^1$ ring : number of halogen atoms or lower carbon substituents substituted in $X^2$ ring) can be (1:0), (0:1), (2:0), (1:1), (0:2), (3:0), (2:1), (1:2), or (0:3). When two of $R^{Xa}$ to $R^{Xd}$ are hydrogen atoms, halogen atoms, or lower carbon substituents, and when the other two are groups of formula (3), one of the $X^1$ ring and $X^2$ ring may be substituted with 2 groups of formula (3), or the $X^1$ ring and the $X^2$ ring each may be substituted with a group of formula (3). It is preferable that the $X^1$ ring and the $X^2$ ring each be substituted with a group of formula (3). In this case, the rings represented by formula (2) are substituted with 0, 1, or 2 halogen atoms or lower carbon substituents, and (number of halogen atoms or lower carbon substituents substituted in $X^1$ ring : number of halogen atoms or lower carbon substituents substituted in $X^2$ ring) can be (1:0), (0:1), (2:0), (1:1), or (0:2) . When one of $R^{Xa}$ to $R^{Xd}$ is a hydrogen atom, a halogen atom, or a lower carbon substituent, and when the other three are groups of formula (3), one of the $X^1$ ring and $X^2$ ring may be substituted with 3 groups of formula (3); the $X^1$ ring may be substituted with 2 groups of formula (3), and the $X^2$ ring may be substituted with 1 group of formula (3); or the $X^1$ ring may be substituted with 1 group of formula (3), and the $X^2$ ring may be substituted with 2 groups of formula (3). It is preferable that the $X^1$ ring be substituted with 2 groups of formula (3), and the $X^2$ ring be substituted with 1 group of formula (3); or that the $X^1$ ring be substituted with 1 group of formula (3), and the $X^2$ ring be substituted with 2 groups of formula (3). In this case, the rings represented by formula (2) are substituted with 0 or 1 halogen atom or lower carbon substituent, and (number of halogen atoms or lower carbon substituents substituted in $X^1$ ring : number of halogen atoms or lower carbon substituents substituted in $X^2$ ring) may be (1:0) or (0:1) . When all of $R^{Xa}$ to $R^{Xd}$ are groups of formula (3), one of the $X^1$ ring and the $X^2$ ring may be substituted with 4 groups of formula (3); the $X^1$ ring may be substituted with 3 groups of formula (3), and the $X^2$ ring may be substituted with 1 group of formula (3); the $X^1$ ring may be substituted with 1 group of formula (3), and the $X^2$ ring may be substituted with 3 groups of formula (3); or the $X^1$ ring may be substituted with 2 groups of formula (3), and the $X^2$ ring may be substituted with 2 groups of formula (3). It is preferable that the $X^1$ ring be substituted with 2 groups of formula (3), and the $X^2$ ring be substituted with 2 groups of formula (3).

As a group of formula (1), a tetravalent group represented by formula (1'):

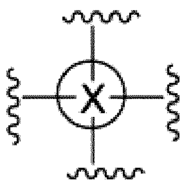

(1')

wherein in formula (1'), X ring is as defined above;
is particularly preferably a group represented by the following formula. Specifically, the group is represented by the following formula:

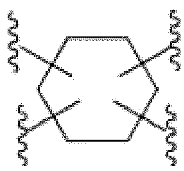

or

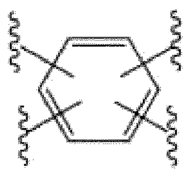

or

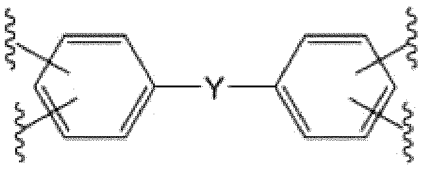

(2g)

wherein in formula (2g), Y is as defined above.

In formula (3), $R^1$ is the same or different, and is a $C_{1-18}$ alkyl group, a $C_{2-9}$ alkenyl group, a cycloalkyl group, an aryl group, or an aralkyl group, wherein one or more carbon atoms of these groups may be replaced by at least one atom selected from the group consisting of an oxygen atom and a nitrogen atom (preferably an oxygen atom). The one or more carbon atoms are preferably carbon atoms that are not directly bonded to the silicon atom. The one or more carbon atoms that may be replaced are one or plural (e.g., 2, 3, 4, 5, or 6) carbon atoms, and preferably one carbon atom. In terms of ease of synthesis etc., it is preferable that $R^1$ bonded to the same silicon atom be the same. It is more preferable that all $R^1$ present in formula (1) be the same.

The $C_{1-18}$ alkyl group represented by $R^1$ is, for example, a linear or branched alkyl group. Examples include a methyl group, an ethyl group, an n-propyl group, an isopropyl group, an n-butyl group, an isobutyl group, a tert-butyl group, an n-pentyl group, a neopentyl group, a tert-pentyl group, an n-hexyl group, an n-heptyl group, a 2,2,4-trimethylpentyl group, an n-octyl group, an isooctyl group, an n-nonyl group, an n-decyl group, an n-dodecyl group, and the like. Preferable is a $C_{1-10}$ alkyl group, more preferable is a $C_{1-6}$ alkyl group, even more preferable is a $C_{1-3}$ alkyl group, and particularly preferable is a methyl group.

The $C_{2-9}$ alkenyl group represented by $R^1$ is, for example, a linear or branched alkenyl group. Examples include a vinyl group, an allyl group, a 2-propenyl group, a butenyl group, a pentenyl group, a hexenyl group, a heptenyl group, an octenyl group, a nonenyl group, and the like. Preferable is a $C_{2-4}$ alkenyl group.

The cycloalkyl group represented by $R^1$ is, for example, a 3- to 8-membered ring cycloalkyl group. Examples include a cyclopentyl group, a cyclohexyl group, a cycloheptyl group, a methylcyclohexyl group, and the like.

The aryl group represented by $R^1$ is, for example, a monocyclic or bicyclic aryl group. Examples include a phenyl group, a tolyl group, a xylyl group, an ethyl phenyl group, a naphthyl group, and the like. Of these, a phenyl group is preferable.

The aralkyl group represented by $R^1$ is, for example, a $C_{1-4}$ alkyl group substituted with an aryl group (particularly a phenyl group). Examples include a benzyl group, an $\alpha$-phenethyl group, a $\beta$-phenethyl group, a $\beta$-methylphenethyl group, and the like.

$R^1$ is preferably a $C_{1-3}$ alkyl group, and more preferably a methyl group.

In formula (3), $R^2$ is a $C_{1-18}$ ($C_1$, $C_2$, $C_3$, $C_4$, $C_5$, $C_6$, $C_7$, $C_8$, $C_9$, $C_{10}$, $C_{11}$, $C_{12}$, $C_{13}$, $C_{14}$, $C_{15}$, $C_{16}$, $C_{17}$, or $C_{18}$) alkylene group. The alkylene group is a linear or branched alkylene group, and preferably a linear alkylene group. Examples include a methylene group, a methylmethylene group, an ethylmethylene group, a dimethylmethylene group, a diethylmethylene group, a dimethylene group ($-CH_2CH_2-$), a trimethylene group ($-CH_2CH_2CH_2-$), a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, and the like. Specific examples include a $C_{2-18}$ alkylene group, preferably a $C_{2-10}$ alkylene group, more preferably a $C_{2-8}$ alkylene group, even more preferably a $C_{2-6}$ alkylene group, and particularly preferably a $C_{2-5}$ alkylene group.

One or more carbon atoms of the $C_{1-18}$ alkylene group may be replaced by at least one atom selected from the group consisting of an oxygen atom and a nitrogen atom (preferably an oxygen atom). The one or more carbon atoms are preferably carbon atoms that are not directly bonded to the silicon atom, and the 3- to 8-membered ring or epoxy ring. Moreover, the one or more carbon atoms that may be replaced are one or plural (e.g., 2, 3, 4, 5, or 6) carbon atoms, and preferably one carbon atom.

When the side of $R^2$ binding to the silicon atom is expressed as (*), examples of this group include (*)-$C_{2-9}$ alkylene-O-$C_{1-8}$ alkylene-, preferably (*)-$C_{2-4}$ alkylene-O-$C_{1-3}$ alkylene-, more preferably (*)-$C_{2-4}$ alkylene-O-$C_{1-2}$ alkylene-, and particularly preferably (*)-$C_3$ alkylene-O-methylene-.

Specific examples include (*)-$(CH_2)_2$-O-$CH_2$-, (*)-$(CH_2)_3$-O-$CH_2$-, (*)-$(CH_2)_3$-O-$(CH_2)_2$-, (*)-$(CH_2)_5$-O-$(CH_2)_4$-, and the like; of these, (*)-$(CH_2)_3$-O-$CH_2$ is preferable.

In formula (3), m is an integer of 0 to 6 (i.e., 0, 1, 2, 3, 4, 5, or 6). Moreover, n is an integer of 0 to 3 (i.e., 0, 1, 2, or 3). The group bonded to $R^2$ of formula (3) (on the side not binding to the silicon atom) is represented by formula (4) (hereafter also referred to as "the group of formula (4)"), as shown below.

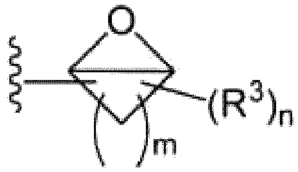

(4)

The group of formula (4) wherein m is an integer of 1 to 6 is specifically described by the following structural formulas.
When m = 1,

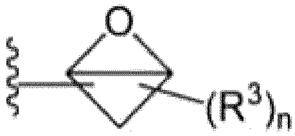

When m = 2,

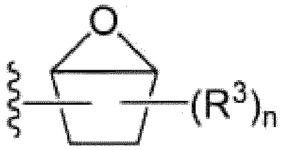

When m = 3,

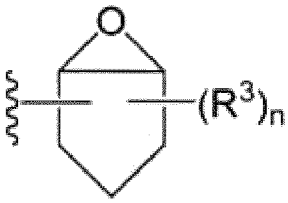

When m = 4,

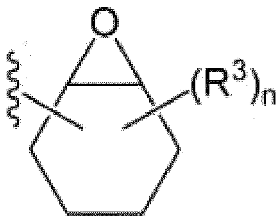

When m = 5,

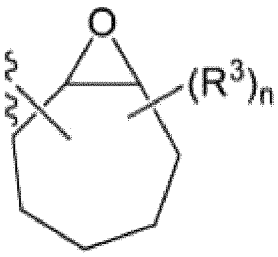

When m = 6,

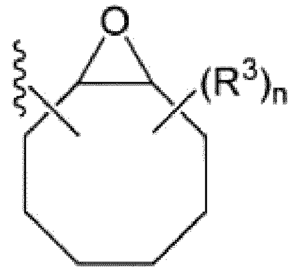

When m is 0, only an epoxy ring remains, and n is an integer of 0 to 3; thus, the group of formula (4) is a group represented by any of the following formulas:

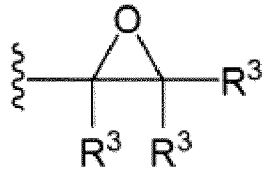
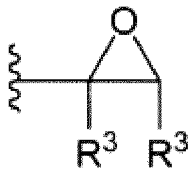
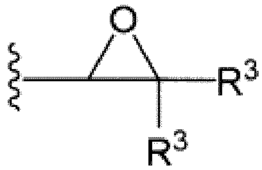
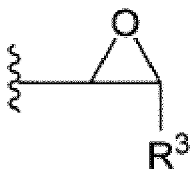
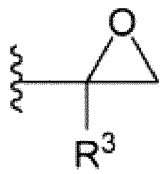
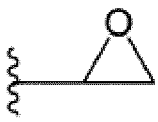

In formula (3), $R^2$ and $R^3$ bind to a 3- to 8-membered ring or an epoxy ring. n represents the number of $R^3$ binding to the 3- to 8-membered ring or the epoxy ring.

In formula (3), $R^3$ is the same or different, and is a $C_{1-18}$ alkyl group, a $C_{2-9}$ alkenyl group, a cycloalkyl group, an aryl group, or an aralkyl group. One or more carbon atoms of these groups may be replaced by at least one atom selected from the group consisting of an oxygen atom and a nitrogen atom. The one or more carbon atoms are preferably carbon atoms that are not directly bonded to the 3- to 8-membered ring or epoxy ring. Moreover, the one or more carbon atoms that may be replaced are one or plural (e.g., 2, 3, 4, 5, or 6) carbon atoms, and preferably one carbon atom.

Examples of the $C_{1-18}$ alkyl group, $C_{2-9}$ alkenyl group, cycloalkyl group, aryl group, and aralkyl group represented by $R^3$ include the same corresponding substituents represented by $R^1$ described above.

$R^3$ is preferably a $C_{1-3}$ alkyl group, and more preferably a methyl group or an ethyl group.

Preferable examples of the group of formula (3) include groups wherein $R^1$, $R^2$, $R^3$, m, and n are as defined above; all $R^1$ are the same; and all $R^3$ are the same (when there are plural $R^3$) . The number of this group present in the epoxy resin represented by formula (1) is 1, 2, 3, or 4; and they may be the same or different, and are preferably the same.

Particularly preferable specific examples of the group of formula (4) include groups wherein $R^3$ is as defined above; m is 0, 1, 2, 3, or 4; and n is 0, 1, or 2. More preferable among these are, for example, the following groups (all $R^3$ are as defined above):

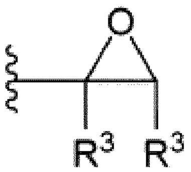
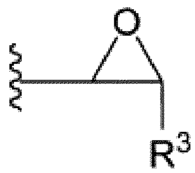
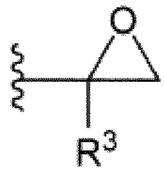
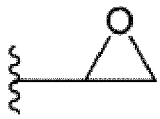

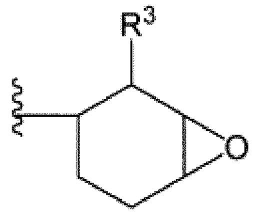 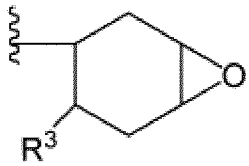 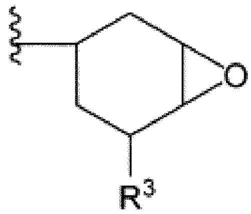 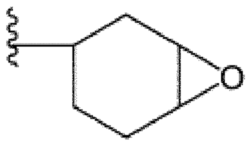

The number of groups of formula (4) present in the epoxy resin represented by formula (1) is 1, 2, 3, or 4; and they may be the same or different, and are preferably the same.

Moreover, one or more hydrogen atoms bonded to one or more carbon atoms that constitute the hydrocarbon ring constituting the X ring, and that are not bonded to $R^{Xa}$, $R^{Xb}$, $R^{Xc}$, or $R^{Xd}$, may be replaced by a lower carbon substituent or a halogen atom (preferably a lower carbon substituent). That is, when the X ring is a saturated hydrocarbon ring or an unsaturated hydrocarbon ring, or rings having a structure in which 2 to 6 saturated hydrocarbon rings and/or unsaturated hydrocarbon rings are condensed, one or more hydrogen atoms bonded to one or more carbon atoms that constitute these rings, and that are not bonded to $R^{Xa}$, $R^{Xb}$, $R^{Xc}$, or $R^{Xd}$, may be replaced by a lower carbon substituent or a halogen atom (preferably a lower carbon substituent). When the X ring is rings having a structure in which 2 saturated hydrocarbon rings and/or unsaturated hydrocarbon rings are connected, one or more hydrogen atoms bonded to one or more carbon atoms that constitute these connected saturated hydrocarbon rings and/or unsaturated hydrocarbon rings, and that are not bonded to $R^{Xa}$, $R^{Xb}$, $R^{Xc}$, or $R^{Xd}$, may be replaced by a lower carbon substituent or a halogen atom (preferably a lower carbon substituent). When the case in which the X ring is rings represented by formula (2) is explained in detail, one or more hydrogen atoms bonded to one or more carbon atoms that constitute the $X^1$ ring and $X^2$ ring, and that are not bonded to $R^{Xa}$, $R^{Xb}$, $R^{Xc}$, or $R^{Xd}$, may be replaced by a lower carbon substituent or a halogen atom (preferably a lower carbon substituent).

In the present specification, carbon atoms that constitute the hydrocarbon ring constituting the X ring, and that are not bonded to $R^{Xa}$, $R^{Xb}$, $R^{Xc}$, and $R^{Xd}$, are also referred to as "$R^{Xa-d}$ non-binding carbon atoms."

The lower carbon substituent or halogen atom that may replace one or more hydrogen atoms bonded to one or more $R^{Xa-d}$ non-binding carbon atoms is preferably singly bonded to one $R^{Xa-d}$ non-binding carbon atom. That is, when hydrogen atoms bonded to $R^{Xa-d}$ non-binding carbon atoms are replaced, only one of the hydrogen atoms bonded to the $R^{Xa-d}$ non-binding carbon atoms is preferably replaced by a lower carbon substituent or halogen atom. Moreover, the number of substituents (i.e., the total number of lower carbon substituents and halogen atoms) is more preferably less than the number of $R^{Xa-d}$ non-binding carbon atoms. More specifically, the number of substituents is preferably 1 to 6 (1, 2, 3, 4, 5, or 6), more preferably 1 to 4, and even more preferably 1 or 2. Particularly when the X ring is rings represented by formula (2), one or more hydrogen atoms to be replaced are preferably hydrogen atoms bonded to carbon atoms that are not bonded to Y.

When at least one of $R^{Xa}$, $R^{Xb}$, $R^{Xc}$, and $R^{Xd}$ is a lower carbon substituent, and when at least one lower carbon substituent is bonded to an $R^{Xa-d}$ non-binding carbon atom, all of the lower carbon substituents are preferably the same. That is, when there are lower carbon substituents among $R^{Xa}$, $R^{Xb}$, $R^{Xc}$, and $R^{Xd}$, and when there are lower carbon substituents bonded to $R^{Xa-d}$ non-binding carbon atoms, all of the lower carbon substituents are preferably the same. Moreover, when at least one of $R^{Xa}$, $R^{Xb}$, $R^{Xc}$, and $R^{Xd}$ is a halogen atom, and when at least one halogen atom is bonded to an $R^{Xa-d}$ non-binding carbon atom, all of the halogen atoms are preferably the same. That is, when there are halogen atoms among $R^{Xa}$, $R^{Xb}$, $R^{Xc}$, and $R^{Xd}$, and when there are halogen atoms bonded to $R^{Xa-d}$ non-binding carbon atoms, all of the halogen atoms are preferably the same.

More specifically, for example, when the tetravalent group represented by the above formula (1') is the following:

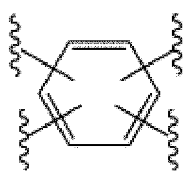

preferable examples of the epoxy resin represented by formula (1) include an epoxy resin represented by formula (1-X1):

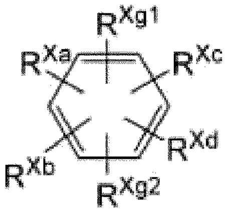

(1-X1)

wherein in formula (1-X1), $R^{Xa}$, $R^{Xb}$, $R^{Xc}$, and $R^{Xd}$ are as defined above; and $R^{Xg1}$ and $R^{Xg2}$ are the same or different, and each is a hydrogen atom, a lower alkyl group, a lower alkoxy group, or a lower alkenyl group.
In formula (1-X1), $R^{Xa}$, $R^{Xb}$, $R^{Xc}$, $R^{Xd}$, $R^{Xg1}$, and $R^{Xg2}$ are more preferably each bonded to a different carbon atom on the benzene ring. Among the epoxy resins represented by formula (1-X1), one wherein $R^{Xg1}$ and $R^{Xg2}$ are hydrogen atoms is preferable.

More preferable examples of the epoxy resin represented by formula (1-X1) include:
an epoxy resin represented by formula (1-X1a):

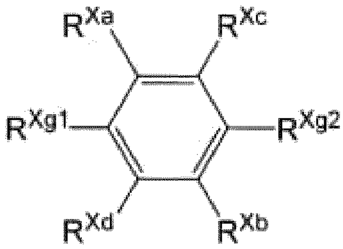

(1-X1a)

wherein in formula (1-X1a) , $R^{Xa}$, $R^{Xb}$, $R^{Xc}$, and $R^{Xd}$ are as defined above; and $R^{Xg1}$ and $R^{Xg2}$ are as defined above; and an epoxy resin represented by formula (1-X1b):

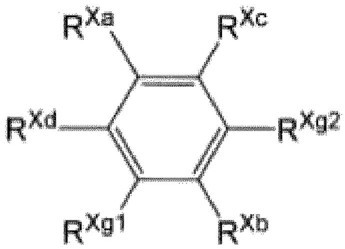

(1-X1b)

wherein in formula (1-X1b), $R^{Xa}$, $R^{Xb}$, $R^{Xc}$, and $R^{Xd}$ are as defined above; and $R^{Xg1}$ and $R^{Xg2}$ are as defined above.

More preferable among the epoxy resins represented by formula (1-X1a) are, for example, those wherein $R^{Xa}$ and $R^{Xb}$ are hydrogen atoms, $R^{Xc}$ and $R^{Xd}$ are groups of formula (3), and $R^{Xg1}$ and $R^{Xg2}$ are hydrogen atoms; and those wherein $R^{Xa}$ and $R^{Xc}$ are hydrogen atoms, $R^{Xb}$ and $R^{Xd}$ are groups of formula (3), and $R^{Xg1}$ and $R^{X92}$ are hydrogen atoms.

More preferable among the epoxy resins represented by formula (1-X1b) are, for example, those wherein $R^{Xa}$ is a hydrogen atom, $R^{Xb}$, $R^{Xc}$, and $R^{Xd}$ are groups of formula (3), and $R^{Xg1}$ and $R^{Xg2}$ are hydrogen atoms.

Moreover, when the tetravalent group represented by the above formula (1') is a group represented by the following formula:

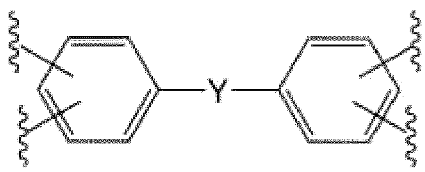

($2^g$)

wherein in formula ($2^g$), Y is as defined above;
preferable examples of the epoxy resin represented by formula (1) also include an epoxy resin represented by formula (1-X2):

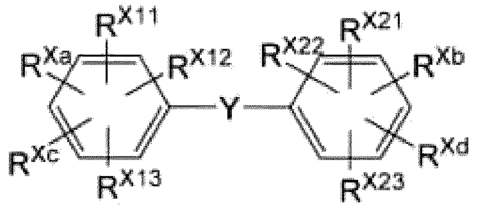

(1-X2)

wherein in formula (1-X2), Y is as defined above; $R^{Xa}$, $R^{Xb}$, $R^{Xc}$, and $R^{Xd}$ are as defined above; and $R^{X11}$, $R^{X12}$, and $R^{X13}$, as well as $R^{X21}$, $R^{X22}$, and $R^{X23}$ are the same or different, and each is a hydrogen atom, a lower alkyl group, a lower alkoxy group, or a lower alkenyl group.
In formula (1-X2), $R^{Xa}$, $R^{Xc}$, $R^{X11}$, $R^{X12}$, and $R^{X13}$ preferably each bind to a different carbon atom; and $R^{Xb}$, $R^{Xd}$, $R^{X21}$, $R^{X22}$, and $R^{X23}$ more preferably each bind to a different carbon atom. None of $R^{Xa}$, $R^{Xb}$, $R^{Xc}$, $R^{Xd}$, $R^{X11}$, $R^{X12}$, $R^{X13}$, $R^{X21}$, $R^{X22}$, and $R^{X23}$ binds to a carbon atom bonded to Y.

More preferable among the epoxy resins represented by formula (1-X2) are:
an epoxy resin represented by formula (1-X2a):

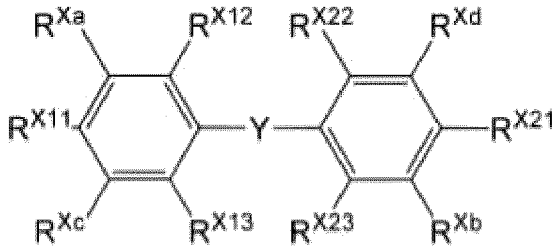

(1-X2a)

wherein in formula (1-X2a), Y is as defined above; $R^{Xa}$, $R^{Xb}$, $R^{Xc}$, and $R^{Xd}$ are as defined above; and $R^{X11}$, $R^{X12}$, and $R^{X13}$, as well as $R^{X21}$, $R^{X22}$, and $R^{X23}$ are the same or different, and each is a hydrogen atom, a lower alkyl group, a lower alkoxy group, or a lower alkenyl group;
an epoxy resin represented by formula (1-X2b):

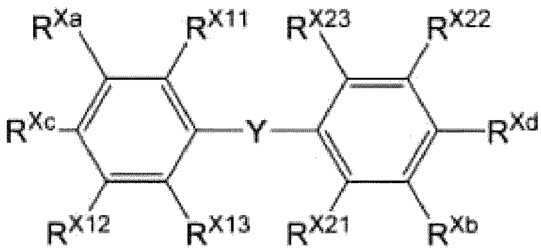

(1-X2b)

wherein in formula (1-X2b), Y is as defined above; $R^{Xa}$, $R^{Xb}$, $R^{Xc}$, and $R^{Xd}$ are as defined above; and $R^{X11}$, $R^{X12}$, and $R^{X13}$, as well as $R^{X21}$, $R^{X22}$, and $R^{X23}$ are the same or different, and each is a hydrogen atom, a lower alkyl group, a lower alkoxy group, or a lower alkenyl group; and
an epoxy resin represented by formula (1-X2c):

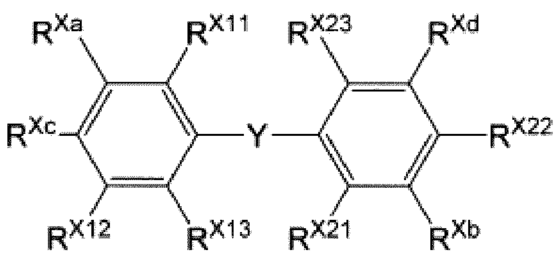

(1-X2c)

wherein in formula (1-X2c), Y is as defined above; $R^{Xa}$, $R^{Xb}$, $R^{Xc}$, and $R^{Xd}$ are as defined above; and $R^{X11}$, $R^{X12}$, and

$R^{X13}$, as well as $R^{X21}$, $R^{X22}$, and $R^{X23}$ are the same or different, and each is a hydrogen atom, a lower alkyl group, a lower alkoxy group, or a lower alkenyl group.

More preferable among the epoxy resins represented by formula (1-X2a) are, for example, those wherein $R^{Xa}$, $R^{Xb}$, $R^{Xc}$, and $R^{Xd}$ are groups of formula (3); $R^{X11}$ and $R^{X21}$ are lower carbon substituents; and $R^{X12}$, $R^{X13}$, $R^{X22}$, and $R^{X23}$ are hydrogen atoms. Particularly preferable are those wherein Y is a $C_{1-6}$ alkylene group that may be substituted with a $C_{1-4}$ alkyl group (particularly $-C(CH_3)_2-$) ; $R^{Xa}$, $R^{Xb}$, $R^{Xc}$, and $R^{Xd}$ are groups of formula (3) ; $R^{X11}$ and $R^{X21}$ are lower alkoxy groups; and $R^{X12}$, $R^{X13}$, $R^{X22}$, and $R^{X23}$ are hydrogen atoms. In these cases, it is more preferable that all of the groups of formula (3) as $R^{Xa}$, $R^{Xb}$, $R^{Xc}$, and $R^{Xd}$ be the same, and that the lower carbon substituents as $R^{X11}$ and $R^{X21}$ be the same.

Preferable among the epoxy resins represented by formula (1-X2b) are, for example, those wherein $R^{Xa}$ and $R^{Xb}$ are hydrogen atoms; $R^{Xc}$ and $R^{Xd}$ are groups of formula (3); and $R^{X11}$, $R^{X12}$, $R^{X13}$, $R^{X21}$, $R^{X22}$, and $R^{X23}$ are hydrogen atoms. In this case, it is more preferable that the groups of formula (3) as $R^{Xc}$ and $R^{Xd}$ be the same.

Preferable among the epoxy resins represented by formula (1-X2c) are, for example, those wherein $R^{Xa}$ is a hydrogen atom; $R^{Xb}$, $R^{Xc}$, and $R^{Xd}$ are groups of formula (3); and $R^{X11}$, $R^{X12}$, $R^{X13}$, $R^{X21}$, $R^{X22}$, and $R^{X23}$ are hydrogen atoms. In this case, it is more preferable that the groups of formula (3) as $R^{Xb}$, $R^{Xc}$, and $R^{Xd}$ be the same.

In the present specification, the explanations relating to the X ring, $R^{Xa}$, $R^{Xb}$, $R^{Xc}$, and $R^{Xd}$ in formula (1), and $R^1$, $R^2$, $R^3$, m, and n in the group of formula (3), including the explanation about the group of formula (4), can be combined in any way. Any epoxy resins represented by combinations thereof can also be used in the present invention.

Formula (1) can satisfy any of the following:

(iia) one or more hydrogen atoms bonded to one or more $R^{Xa-d}$ non-binding carbon atoms are not replaced; $R^{Xa}$ and $R^{Xb}$ of $R^{Xa}$, $R^{Xb}$, $R^{Xc}$, and $R^{Xd}$ are hydrogen atoms; and $R^{Xc}$ and $R^{Xd}$ are groups of formula (3) ;

(iiia) one or more hydrogen atoms bonded to one or more $R^{Xa-d}$ non-binding carbon atoms are not replaced; $R^{Xa}$ of $R^{Xa}$, $R^{Xb}$, $R^{Xc}$, and $R^{Xd}$ is a hydrogen atom; and $R^{Xb}$, $R^{Xc}$, and $R^{Xd}$ are groups of formula (3); or

(iva) one or more hydrogen atoms bonded to one or more $R^{Xa-d}$ non-binding carbon atoms are not replaced; and all of $R^{Xa}$, $R^{Xb}$, $R^{Xc}$, and $R^{Xd}$ are groups of formula (3) .

In the case of (iia), preferable examples of the epoxy resin represented by formula (1) include an epoxy resin represented by the following formula (1-iia):

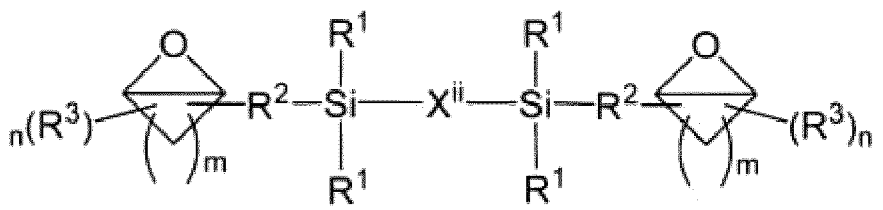

(1－ｉｉａ)

wherein $X^{ii}$ is a divalent group obtained by removing two hydrogen atoms from a hydrocarbon ring, or a divalent group represented by formula ($2^g$-iia):

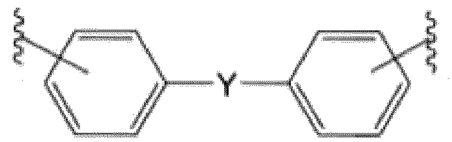

($2^g$－ｉｉａ)

wherein Y is as defined above; and

$R^1$, $R^2$, $R^3$, m, and n are as defined above.

$R^1$, $R^2$, $R^3$, m, and n each may be the same or different, and are preferably the same.

The divalent group represented by $X^{ii}$ is preferably a cyclohexane-1,4-diyl group or a 1,4-phenylene group; and more preferably a 1,4-phenylene group.

Preferable among the divalent groups represented by formula ($2^g$-iia) is a group represented by formula ($2^g$-iia'):

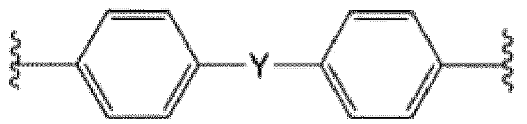

(2g-iia')

wherein Y is as defined above.

In formula (2g-iia'), Y is preferably a bond, a dimethylmethylene group, an oxygen atom, or $-SO_2-$.

$X^{ii}$ is preferably a cyclohexane-1,4-diyl group, a 1,4-phenylene group, or a group of formula (2g-iia'); and more preferably a 1,4-phenylene group.

The present invention can more preferably use, for example, an epoxy resin represented by formula (1-iia), wherein m is the same and is 0, 1, 2, 3, or 4 (particularly preferably m is the same and is 0 or 4); n is the same and is 0 (that is, the ring is not substituted with $R^3$) $X^{ii}$ is a divalent group obtained by removing two hydrogen atoms from a hydrocarbon ring (particularly preferably a benzene ring); $R^1$ is the same and is a $C_{1-3}$ alkyl group; and $R^2$ is the same and is a $C_{2-6}$ alkylene group, wherein one carbon atom that is not directly bonded to the silicon atom, and the 3- to 6-membered ring or epoxy ring may be replaced by an oxygen atom.

In the case of (iiia), the epoxy resins represented by formula (1) preferably include an epoxy resin represented by the following formula (1-iiia):

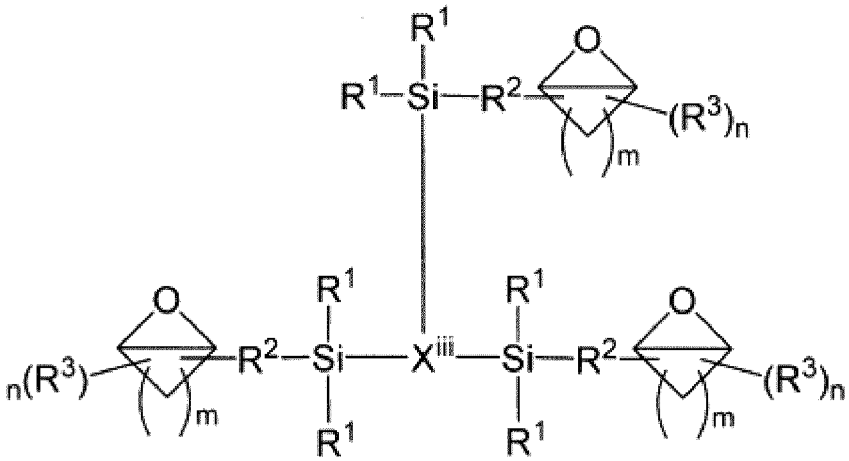

(1-iiia)

wherein $X^{iii}$ is a trivalent group obtained by removing three hydrogen atoms from a hydrocarbon ring, or a trivalent group represented by formula (2g-iiia):

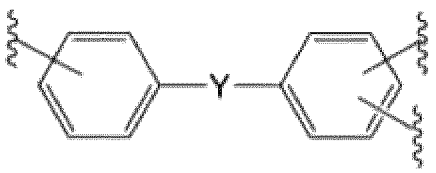

(2g-iiia)

wherein Y is as defined above; and

$R^1$, $R^2$, $R^3$, m, and n are as defined above.
$R^1$, $R^2$, $R^3$, m, and n each may be the same or different, and are preferably the same.

Preferable examples of the trivalent group represented by $X^{iii}$ include the following groups:

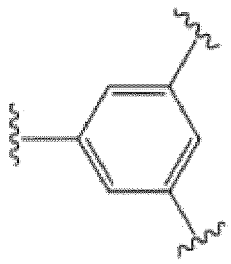
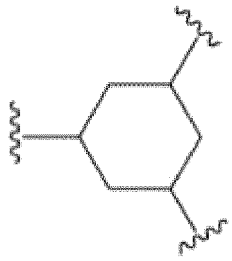

Preferable among the trivalent groups represented by formula ($2^g$-iiia) include a group represented by formula ($2^g$-iiia'):

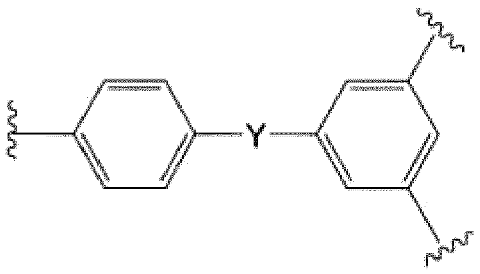
($2^g$-iiia')

wherein Y is as defined above.

In formula ($2^g$-iiia'), Y is particularly preferably a bond, a dimethylmethylene group, an oxygen atom, or $-SO_2-$.

The present invention can more preferably use, for example, an epoxy resin represented by formula (1-iiia), wherein m is the same and is 0, 1, 2, 3, or 4 (particularly preferably m is the same and is 0 or 4); n is the same and is 0 (that is, the ring is not substituted with $R^3$); $X^{iii}$ is a trivalent group obtained by removing three hydrogen atoms from a hydrocarbon ring (particularly preferably a benzene ring) ; $R^1$ is the same and is a $C_{1-3}$ alkyl group; and $R^2$ is the same and is a $C_{2-6}$ alkylene group, wherein one carbon atom that is not directly bonded to the silicon atom and the 3- to 6-membered ring or epoxy ring may be replaced by an oxygen atom.

In the case of (iva), the epoxy resins represented by formula (1) include an epoxy resin represented by the following formula (1-iva):

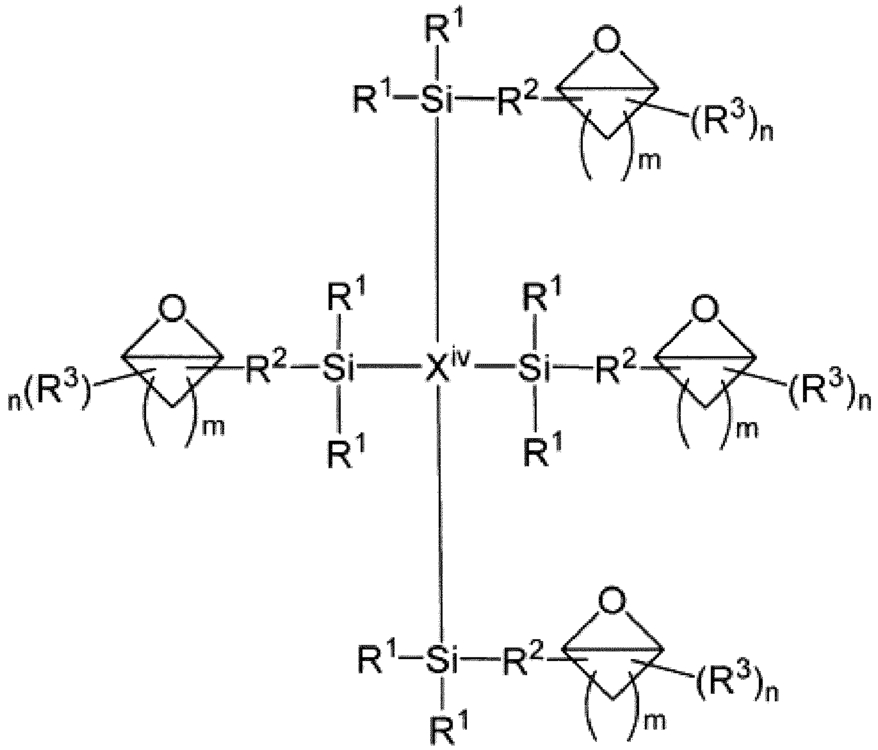

(1 − i v a)

wherein $X^{iv}$ is a tetravalent group represented by the above formula (1'), wherein one or more hydrogen atoms bonded to one or more $R^{Xa-d}$ non-binding carbon atoms in the X ring are not replaced; and $R^1$, $R^2$, $R^3$, m, and n are as defined above.

$R^1$, $R^2$, $R^3$, m, and n each may be the same or different, and are preferably the same.

Preferable examples of the tetravalent group represented by $X^{iv}$ include the following groups:

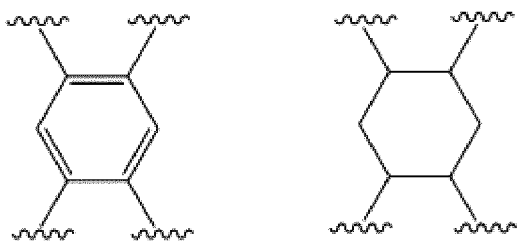

As the tetravalent group represented by $X^{iv}$, among tetravalent groups represented by formula ($2^g$), wherein one or more hydrogen atoms bonded to one or more $R^{Xa-d}$ non-binding carbon atoms are not replaced, preferable is a group represented by formula ($2^g$-iva'):

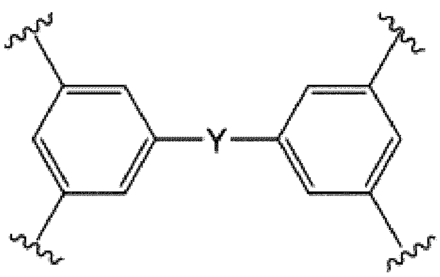

($2^g$ − i v a')

wherein Y is as defined above.

In formula ($2^g$-iva'), Y is particularly preferably a bond, a dimethylmethylene group, an oxygen atom, or $-SO_2-$.

The present invention can more preferably use, for example, an epoxy resin represented by formula (1-iva),

wherein m is the same and is 0, 1, 2, 3, or 4 (particularly preferably m is the same and is 0 or 4); n is the same and is 0 (that is, the ring is not substituted with $R^3$); $X^{iv}$ is a tetravalent group obtained by removing four hydrogen atoms from a hydrocarbon ring (particularly preferably a benzene ring); $R^1$ is the same and is a $C_{1-3}$ alkyl group; and $R^2$ is the same and is a $C_{2-6}$ alkylene group, wherein one carbon atom that is not directly bonded to the silicon atom and the 3- to 6-membered ring or epoxy ring may be replaced by an oxygen atom.

More preferable among the epoxy resins represented by formula (1) are specifically, for example, compounds represented by formula (1-IIa):

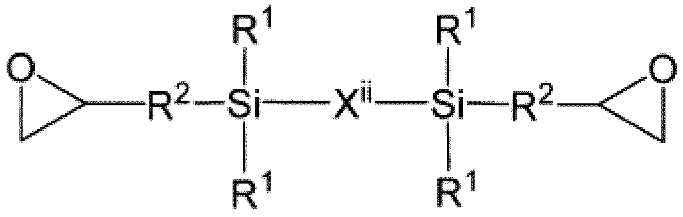

(1-IIa)

wherein $R^1$, $R^2$, and $X^{ii}$ are as defined above.

Preferable among the compounds represented by formula (1-IIa) are compounds wherein $X^{ii}$ is a 1,4-phenylene group or a group represented by formula ($2^g$-iia') (preferably a 1,4-phenylene group); $R^1$ is the same or different (preferably the same), and is a $C_{1-3}$ alkyl group (particularly a methyl group); and $R^2$ is the same or different (preferably the same), and is a $C_{2-6}$ alkylene group, (*)-$(CH_2)_2$-O-$CH_2$-, (*)-$(CH_2)_3$-O-$CH_2$-, (*)-$(CH_2)_3$-O-$(CH_2)_2$-, or (*)-$(CH_2)_5$-O-$(CH_2)_4$-. (*) represents the side of $R^2$ binding to the silicon atom, as described above.

More preferable among the epoxy resins represented by the above formula (1-IIa) is:
an epoxy resin represented by formula (1-IIa1):

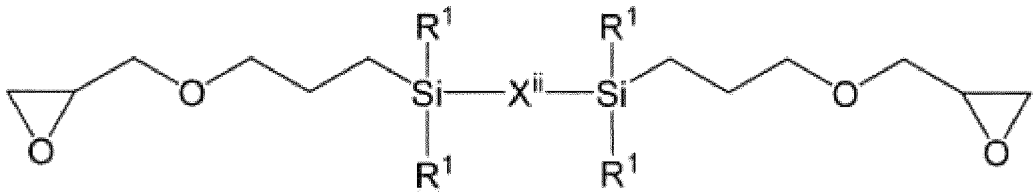

(1-IIa1)

wherein $R^1$ and $X^{ii}$ are as defined above; or
an epoxy resin represented by formula (1-IIa2):

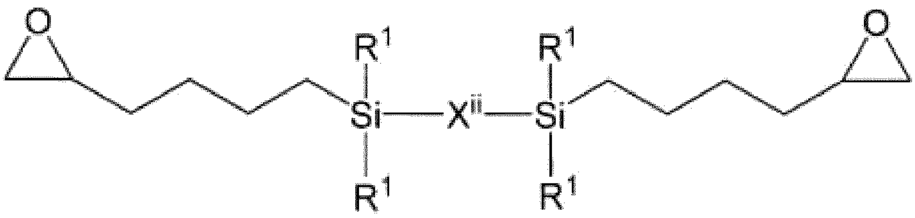

(1-IIa2)

wherein $R^1$ and $X^{ii}$ are as defined above.
$R^1$ may be the same or different, and is preferably the same.

More preferably, in formula (1-IIa1) or (1-IIa2), $R^1$ is the same or different (preferably the same), and is a $C_{1-3}$ alkyl group (particularly a methyl group); and $X^{ii}$ is a 1,4-phenylene group or a group represented by formula ($2^g$-iia').

More preferable among the epoxy resins represented by formula (1) include an epoxy resin represented by formula (1-IIb) :

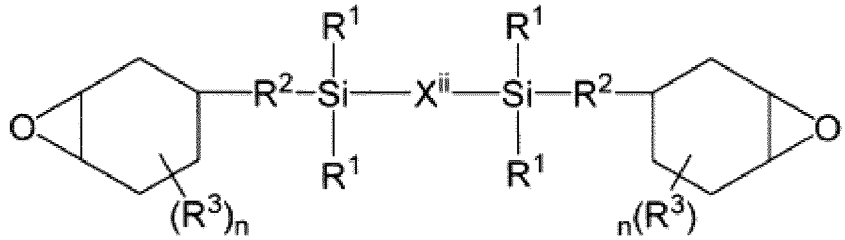

(1-IIb)

wherein $R^1$, $R^2$, $R^3$, $X^{ii}$, and n are as defined above.

$R^1$, $R^2$, $R^3$, and n each may be the same or different, and are preferably the same.

More preferably, in formula (1-IIb), $X^{ii}$ is a 1,4-phenylene group or a group represented by formula ($2^g$-iia') (preferably a 1,4-phenylene group); $R^1$ is the same or different (preferably the same), and is a $C_{1-3}$ alkyl group (particularly a methyl group); both n is 0 (that is, the ring is not substituted with $R^3$); and $R^2$ is the same or different (preferably the same), and is a $C_{2-6}$ alkylene group (preferably a dimethylene group: $-(CH_2)_2-$).

More preferable among the epoxy resins represented by formula (1) is an epoxy resin represented by formula (1-IIIa):

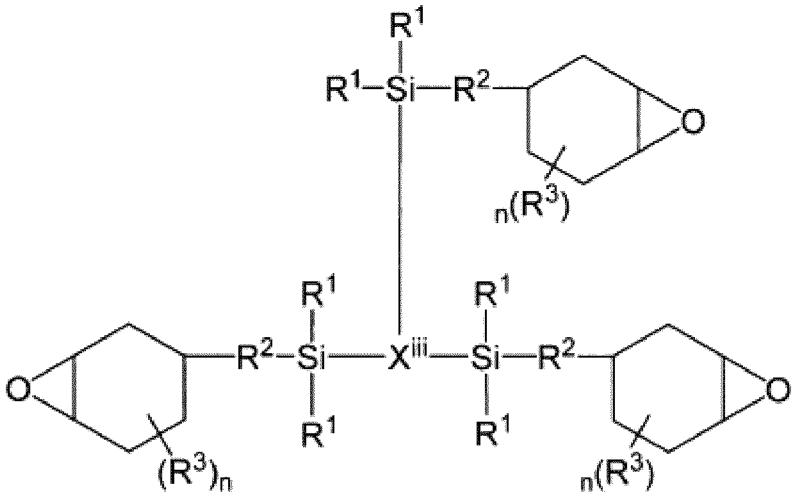

(1-IIIa)

wherein $R^1$, $R^2$, $R^3$, $X^{iii}$, and n are as defined above.

$R^1$, $R^2$, $R^3$, and n each may be the same or different, and are preferably the same.

More preferably, in formula (1-IIIa), $X^{iii}$ is

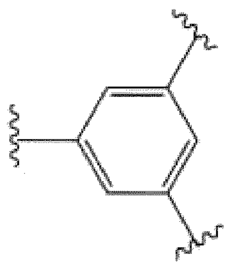

or

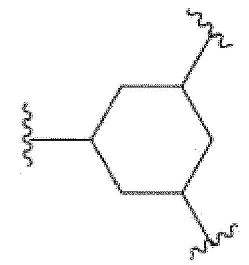

or a group represented by formula (2g-iiia'); $R^1$ is the same or different (preferably the same), and is a $C_{1-3}$ alkyl group (particularly a methyl group); both n is 0 (that is, the ring is not substituted with $R^3$); and $R^2$ is the same or different (preferably the same), and is a $C_{2-6}$ alkylene group (preferably a dimethylene group: $-(CH_2)_2-$).

In the epoxy resin composition of the present invention, the epoxy resins represented by formula (1) can be used singly or in combination of two or more.

The epoxy resin represented by formula (1) can be produced by or according to a known method, for example, based on or according to the disclosure of patent literature (GB1123960B). Moreover, the epoxy resin represented by formula (1-iia) can be produced by, for example, a reaction represented by the following reaction formula:

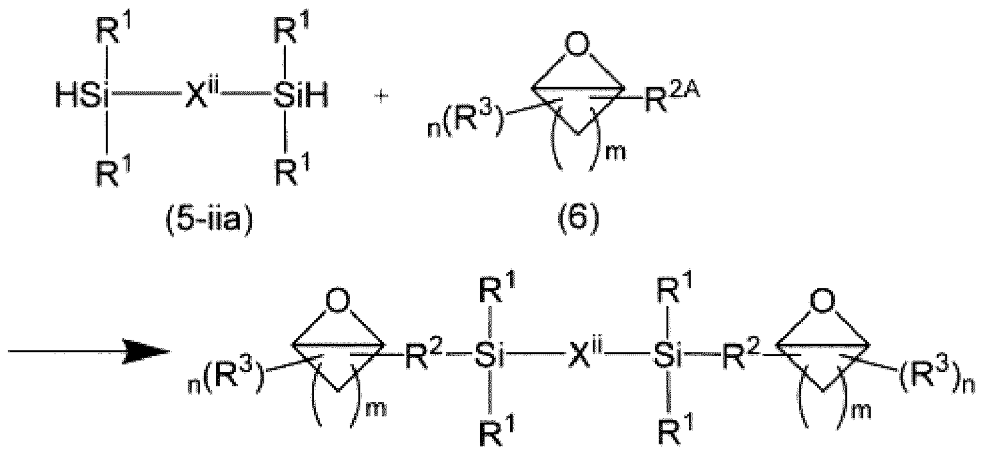

(5-iia) (6)

(1-iia)

wherein $R^{2A}$ is a $C_{2-18}$ alkenyl group, wherein one or more carbon atoms of this group may be replaced by at least one atom selected from the group consisting of an oxygen atom and a nitrogen atom; and $R^1$, $R^2$, $R^3$, and $X^{ii}$ are as defined above.

The $C_{2-18}$ alkenyl group represented by $R^{2A}$ is a linear or branched alkenyl group, and preferably a linear alkenyl group. Specific examples include a vinyl group, an allyl group, a propenyl group, a butenyl group, a pentenyl group, a hexenyl group, a heptenyl group, an octenyl group, a norbornenyl group, a cyclohexenyl group, and the like. A $C_{2-10}$ alkenyl group is preferable; a $C_{2-8}$ alkenyl group is more preferable; a $C_{2-6}$ alkenyl group is even more preferable; and a vinyl group, an allyl group, or a butenyl group is particularly preferable. The alkenyl group is preferably an $\alpha$-alkenyl group.

One or more carbon atoms of these $C_{2-18}$ alkylene groups may be replaced by at least one atom selected from the group consisting of an oxygen atom and a nitrogen atom (preferably an oxygen atom). The one or more carbon atoms are preferably carbon atoms that are not directly bonded to the epoxy ring. Moreover, the one or more carbon atoms that may be replaced are one or plural (e.g., 2, 3, 4, 5, or 6) carbon atoms, and preferably one carbon atom. Examples of this group include $C_{2-9}$ alkenyl-O-$C_{1-8}$ alkylene-, preferably $C_{2-4}$ alkenyl-O-$C_{1-3}$ alkylene-, more preferably $C_{2-4}$ alkenyl-O-$C_{1-2}$ alkylene-, and particularly preferably $C_3$ alkenyl-O-$CH_2$-. Specific examples include $CH_2 = CHO-CH_2-$, $CH_2 = CH-CH_2-O-CH_2-$, $CH_2 = CH-CH_2-O-(CH_2)_2-$, $CH_2 = CH-(CH_2)_3-O-(CH_2)_4-$, and the like; among these, $CH_2 = CH-CH_2-O-CH_2-$(allyloxymethyl group) is preferable.

The epoxy resin represented by formula (1-iia) can be produced by hydrosilylation of the compound represented by formula (5-iia) and the compound represented by formula (6). Hydrosilylation can be generally performed in the presence of a catalyst in the presence or absence of a solvent. Moreover, when a compound represented by formula (5-iiia):

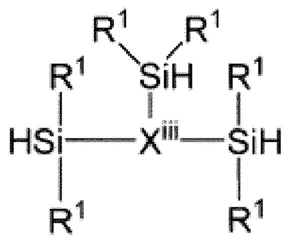

(5-iiia)

wherein $R^1$ and $X^{iii}$ are as defined above; or
formula (5-iva):

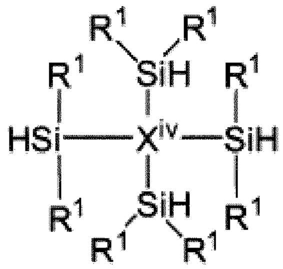

(5-iva)

wherein $R^1$ and $X^{iv}$ are as defined above;
is used in place of the compound represented by formula (5-iia), an epoxy resin represented by the above formula (1-iiia) or (1-iva), or an epoxy resin having a structure in which one group of formula (3) is bonded to a hydrocarbon ring can also be produced. Moreover, various compounds represented by formula (1) can be produced by using compounds having a structure in which $X^{ii}$ to $X^{iv}$ are each replaced by a divalent group obtained by removing two hydrogen atoms from the X ring, a trivalent group obtained by removing three hydrogen atoms from the X ring, or a tetravalent group obtained by removing four hydrogen atoms from the X ring.

The catalyst used in hydrosilylation may be a known catalyst. Examples include platinum-based catalysts, such as platinum carbon, chloroplatinic acid, olefin complexes of platinum, alkenylsiloxane complexes of platinum, and carbonyl complexes of platinum; rhodium-based catalysts, such as tris(triphenylphosphine)rhodium; and iridium-based catalysts, such as bis(cyclooctadienyl)dichloroiridium. These catalysts may be in the form of solvates (e.g., hydrates, alcoholates, etc.). Further, the catalyst may be used in the form of a solution obtained by dissolving the catalyst in an alcohol (e.g., ethanol) when used. These catalysts can be used singly or in a combination of two or more.

The amount of the catalyst used may be an effective amount as the catalyst. For example, the amount of the catalyst used is 0.00001 to 20 parts by mass, and preferably 0.0005 to 5 parts by mass, based on the total amount of 100 parts by mass of the compound represented by formula (5-iia), (5-iiia), or (5-iva), and the compound represented by formula (6).

Although hydrosilylation proceeds without use of a solvent, the reaction can be carried out under milder conditions by using a solvent. Examples of solvents include aromatic hydrocarbon solvents, such as toluene and xylene; aliphatic hydrocarbon solvents, such as hexane and octane; ether solvents, such as tetrahydrofuran and dioxane; alcohol solvents, such as ethanol and isopropanol; and the like. These may be used singly or in a combination of two or more.

The amount of the compound represented by formula (6) used is, for example, generally 0.5 to 2 mol, preferably 0.6 to 1.5 mol, and more preferably 0.8 to 1.2 mol, per mol of the Si-H group in the compound represented by formula (5-iia), (5-iiia), or (5-iva).

The reaction temperature is generally 0°C to 150°C, and preferably 10°C to 120°C. The reaction time is generally about 1 hour to 24 hours.

After completion of the reaction, the solvent is distilled off from the reaction mixture, or a known isolation method is used, thereby obtaining an epoxy resin represented by formula (1).

The content of the epoxy resin in the epoxy resin composition is, for example, about 10 to 40 mass% or about 15 to 40 mass%.

The epoxy equivalent of the epoxy resin is, for example, preferably about 50 to 3000, more preferably about

80 to 2000, and even more preferably about 100 to 1000, or about 100 to 500. The epoxy equivalent is measured according to JIS K7236. More specifically, the epoxy equivalent is calculated by dissolving a weighed epoxy resin in chloroform, adding acetic acid and a tetraethylammonium bromide-acetic acid solution, adding a 0.1 mol/L perchloric acid-acetic acid standard solution dropwise using a potentiometric titration device (Hiranuma *Automatic Titrator* COM-1700A, produced by Hiranuma Co., Ltd.), and detecting the end point at which all epoxy groups have reacted. The epoxy equivalent is the mass of a resin containing one equivalent of epoxy groups.

The epoxy resin is an epoxy resin the cured product of which alone preferably has a relative dielectric constant at a frequency of 10 GHz at 25°C of 3.0 or less, and more preferably 2.9 or less or 2.8 or less. Further, the epoxy resin is an epoxy resin the cured product of which alone preferably has a dielectric loss tangent at a frequency of 10 GHz at 25°C of 0.030 or less, more preferably 0.028 or less, and even more preferably 0.015 or less. In the present specification, the cured product of an epoxy resin alone refers to the cured product of an epoxy resin composition comprising 100 parts by mass of an epoxy resin and 1.0 to 2.0 parts by mass of a curing accelerator. The cured product of an epoxy resin alone may be simply referred to as the cured product of an epoxy resin. The relative dielectric constant and the dielectric loss tangent are measured by a cavity resonator perturbation method. For example, the relative dielectric constant and the dielectric loss tangent can be measured using a dielectric constant measurement device (a network analyzer).

Examples of the acid-modified polyolefin include a polyolefin modified with an acid-modified group, such as a carboxyl group or an acid anhydride group.

Specific preferable examples of the acid-modified polyolefin include an acid-modified polyolefin obtained by grafting a polyolefin with an acid-modified group (an acid-modified group-grafted acid-modified polyolefin), an acid-modified polyolefin obtained by copolymerizing an olefin and at least one member selected from the group consisting of an unsaturated carboxylic acid and an acid anhydride thereof (an acid-modified group-copolymerized acid-modified polyolefin), acid-modified polyolefins obtained by further hydrogenating these acid-modified polyolefins (a hydrogenated acid-modified group-grafted acid-modified polyolefin and a hydrogenated acid-modified group-copolymerized acid-modified polyolefin), and the like. It is more preferable that the acid-modified group-grafted acid-modified polyolefin and the acid-modified polyolefin copolymerized with an acid-modified group do not have an unsaturated bond in their main chain.

Preferable examples of the polyolefin in the acid-modified polyolefin grafted with an acid-modified group (in other words, the polyolefin before the polyolefin is grafted with an acid-modified group) include polyethylene, polypropylene, and an olefin copolymer.

Examples of olefin copolymers include propylene-$\alpha$-olefin copolymers, olefin-cyclic olefin copolymers, olefin-styrene copolymers, and the like.

Propylene-$\alpha$-olefin copolymers are obtained by copolymerization of propylene and $\alpha$-olefins. Examples of $\alpha$-olefins include ethylene, 1-butene, 1-heptene, 1-octene, 4-methyl-1-pentene, and the like. These $\alpha$-olefins can be used singly or in a combination of two or more. Further, other monomers, such as vinyl acetate, may be combined and copolymerized. Examples of olefin-cyclic olefin copolymers include copolymers of ethylene or propylene, and tetracyclododecene, and the like.

Examples of olefin-styrene copolymers include a styrene-butadiene copolymer, a styrene-ethylene propylene copolymer, a styrene-butadiene-styrene copolymer, a styreneisoprene-styrene copolymer, a styrene-ethylene butylene-styrene copolymer, a styrene-ethylene propylene-styrene copolymer, and the like.

The method for producing the acid-modified polyolefin grafted with an acid-modified group is not particularly limited, and a known method can be used. For example, radical graft reaction of polyolefins can be used. More specifically, for example, a radical species is generated in a polymer serving as a main chain, and unsaturated carboxylic acid and/or unsaturated carboxylic anhydride is graft-polymerized using the radical species as a polymerization starting point.

Examples of the unsaturated carboxylic acid and/or unsaturated carboxylic anhydride include unsaturated monocarboxylic acids, such as acrylic acid, butanoic acid, crotonic acid, vinylacetic acid, methacrylic acid, pentenoic acid, dodecenoic acid, linoleic acid, angelic acid, and cinnamic acid; unsaturated dicarboxylic acids, such as maleic acid, fumaric acid, chloromaleic acid, and himic acid; unsaturated carboxylic anhydrides, such as maleic anhydride, himic anhydride, and acrylic anhydride; and the like. Among these, maleic anhydride can be particularly suitably used.

The number average molecular weight of the acid-modified polyolefin is not particularly limited, and is preferably 2000 to 300000, and more preferably 3000 to 200000. Moreover, the equivalent ratio of epoxy groups in the epoxy resin to acid-modified groups in the acid-modified polyolefin (particularly when it is an acid-modified polyolefin with a number average molecular weight of 20000 or less) (epoxy groups/acid-modified groups) in the epoxy resin composition is preferably about 0.5 to 6 in terms of heat resistance. The lower limit is more preferably 0.8, and the upper limit is more preferably 3. The number average molecular weight is measured by gel permeation chromatography (GPC). The number average molecular weight of the acid-modified polyolefin is determined by comparison with polystyrene with known number average molecular weight measured under the same conditions by GPC.

The acid value (mgKOH/g) of the acid-modified polyolefin is not particularly limited, and is preferably 0.5 to 500, and more preferably 2 to 300.

Moreover, the functional group equivalent (g/mol) of the acid-modified group of the acid-modified polyolefin is not particularly limited, and is preferably 100 to 100000, and more preferably 100 to 50000, or 200 to 30000.

The relative dielectric constant of the acid-modified polyolefin at a frequency of 10 GHz at 25°C is preferably 3.0 or less, more preferably 2.8 or less, and even more preferably 2.6 or less. The dielectric loss tangent of the acid-modified polyolefin at a frequency of 10 GHz at 25°C is preferably 0.003 or less, more preferably 0.0028 or less, and even more preferably 0.0025 or less. The relative dielectric constant and the dielectric loss tangent of the acid-modified polyolefin are measured by a cavity resonator perturbation method.

The acid-modified polyolefins can be used singly or in a combination of two or more.

The epoxy resin composition may contain, for example, curing agents, curing accelerators, thermoplastic resins other than acid-modified polyolefins, fillers, additives, etc., if necessary, within a range that does not impair the objects and effects of the present invention. It is particularly preferred that the epoxy resin composition contains a curing agent.

The curing agent is not particularly limited as long as it has a function of curing the epoxy resin. Examples include amine-based curing agents, amide-based curing agents, acid anhydride-based curing agents, phenol-based curing agents, benzoxazine-based curing agents, naphthol-based curing agents, mercaptan-based curing agents, isocyanate-based curing agents, active ester-based curing agents, cyanate ester-based curing agents, carbodiimide-based curing agents, and the like. In terms of improving the dielectric characteristics (in particular, reducing the dielectric loss tangent) of the cured product and maintaining heat resistance, acid anhydride-based curing agents, phenol-based curing agents, benzoxazine-based curing agents, naphthol-based curing agents, active ester-based curing agents, and cyanate ester-based curing agents are preferable, and acid anhydride-based curing agents, benzoxazine-based curing agents, and active ester-based curing agents are more preferable. The curing agents can be properly used corresponding to the required characteristics, and may be used singly or in a combination of two or more.

The mixing ratio of the curing agent in the epoxy resin composition of the present invention is not particularly limited within the range in which the effects of the present invention can be exhibited. For example, the ratio of the equivalent of reactive functional groups in the curing agent to the equivalent of epoxy groups in the epoxy resin is preferably 10:90 to 90:10, more preferably 20:80 to 80:20, even more preferably 30:70 to 70:30, and still even more preferably 40:60 to 60:40.

Examples of curing accelerators include imidazoles, such as 2-methylimidazole, 2-ethylimidazole, 2-phenylimidazole, 2-ethyl-4-methylimidazole, 1,2-dimethylimidazole, 1-(2-cyanoethyl)-2-ethyl-4-methylimidazole, 2-undecylimidazole, and 2-phenylimidazoline; tertiary amines, such as 2-(dimethylaminomethyl)phenol, triethylenediamine, triethanolamine, 4-dimethylaminopyridine, 1,8-diazabicyclo(5,4,0)undecene-7, 1,5-diazabicyclo(4,3,0)-nonen-5, 1,8-bis(dimethylamino)naphthalene, 1,1,3,3-tetramethylguanidine, 7-methyl-1,5,7-triazabicyclo[4.4.0]dec-5-ene, and 1,5,7-triazabicyclo[4.4.0]dec-5-ene; organic phosphines, such as triphenylphosphine, diphenylphosphine, and tributylphosphine; metal compounds, such as tin octylate; phosphonium salts, such as ethyltriphenylphosphonium bromide and tetraphenylphosphonium tetraphenylborate; and the like. In terms of increasing the curability of the resin composition, 2-ethyl-4-methylimidazole, 1,2-dimethylimidazole, 4-dimethylaminopyridine, and triphenylphosphine are more preferable.

The amount of the curing accelerator used is not particularly limited, and is, for example, preferably 0.01 to 10.0 parts by mass, and more preferably 0.1 to 5 parts by mass, per 100 parts by mass of the epoxy resin in the resin layer.

Examples of thermoplastic resins other than acid-modified polyolefins include polyolefin resins, acrylic resins, phenoxy resins, polyamide resins, polyester resins, polycarbonate resins, polyurethane resins, polyarylate resins, polyphenylene ether resins, polyacetal resins, acid-modified products thereof, and the like. In terms of compatibility with the epoxy resin composition of the present invention and heat resistance, for example, polyolefin resins, acrylic resins, phenoxy resins, polyarylate resins, polyphenylene ether resins, and the like are preferable.

The above fillers can be used singly or in a combination of two or more, in consideration of flowability, heat resistance, low thermal expansion properties, mechanical characteristics, hardness, scratch resistance, adhesion, etc. that are required for compositions and cured products, as necessary. Examples include inorganic compounds, such as silica (specifically crystalline silica, fused silica, spherical fused silica, etc.), titanium oxide, zirconium oxide, zinc oxide, tin oxide, silicon nitride, silicon carbide, boron nitride, calcium carbonate, calcium silicate, potassium titanate, aluminum nitride, indium oxide, alumina, antimony oxide, cerium oxide, magnesium oxide, iron oxide, and tin-doped indium oxide (ITO). Other examples include metals, such as gold, silver, copper, aluminum, nickel, iron, zinc, and stainless steel. Still other examples include minerals, such as montmorillonite, talc, mica, boehmite, kaolin, smectite, zonolite, vermiculite, and sericite. Examples of other fillers include carbon compounds, such as carbon black, acetylene black, Ketjen black, and carbon nanotubes; metal hydroxides, such as aluminum hydroxide and magnesium hydroxide; various types of glass, such as glass beads, glass flakes, and glass balloons; and the like. In terms of the heat resistance and flowability of the epoxy resin composition, inorganic compounds are preferable; in particular, silica and alumina are more preferable. The filler may be used in a powder form, or may be used after being dispersed in a resin.

Examples of additives include coupling agents, antioxidants, inorganic fluorescent substances, lubricants, ultraviolet absorbers, heat light stabilizers, antistatic agents, polymerization inhibitors, antifoaming agents, solvents, anti-aging agents, radical inhibitors, adhesion-improving agents, flame retardants, surfactants, storage stability-improving agents, ozone aging inhibitors, thickeners, plasticizers, radiation-blocking agents, nucleating agents, conductivity-imparting agents, phosphorus-based peroxide-decomposing agents, pigments, metal deactivators, physical property-controlling agents, and the like.

The epoxy resin composition preferably contains the epoxy resin and the curing agent in a total amount of about 25 to 75 mass% based on the epoxy resin composition. The upper or lower limit of this range may be, for example, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, or 74 mass%. For example, the above range may be about 30 to 70 mass%.

The cured product of the epoxy resin composition preferably has a dielectric loss tangent at a frequency of 10 GHz at 25°C of 0.010 or less, more preferably 0.008 or less, and even more preferably 0.005 or less. A lower dielectric loss tangent is preferable. Thus, the lower limit is not particularly limited, and is, for example, 0.00005 or more, 0.0001 or more, or 0.0005 or more. The cured product of the resin composition preferably has a relative dielectric constant at a frequency of 10 GHz at 25°C of 3.0 or less, more preferably 2.9 or less, 2.8 or less, 2.7 or less, or 2.6 or less, and even more preferably 2.5 or less or 2.4 or less. A lower relative dielectric constant is preferable. Thus, the lower limit is not particularly limited, and is, for example, 1.0 or more, 1.5 or more, or 2.0 or more. The dielectric loss tangent and the relative dielectric constant can be measured by a cavity resonator perturbation method. The measurement can be performed using, for example, a network analyzer.

In the laminate according to the present disclosure, (i) a test piece composed of the laminate and a prepreg has a 90-degree (90°) peel strength between the laminate and the prepreg of 0.6 N/mm or more as measured in accordance with JISC6481, and (ii) the test piece has a reduction rate of the 90-degree peel strength between the laminate and the prepreg of 20% or less after immersion of the test piece in boiling water for 2 hours. More specifically, the test piece is obtained by placing the epoxy resin composition layer side of the laminate on a prepreg and bonding (curing) them by pressing at a pressing pressure of 2.5 MPa at a pressing temperature of 180°C for 45 minutes and then at 200°C for 2 hours. The peel strength is, more specifically, the peel strength measured when the laminate is pulled at 90 degrees with respect to the prepreg at a test rate of 50 mm/min. In the peel strength measurement, detachment may occur between the copper foil and the epoxy resin layer or between the epoxy resin layer and the prepreg in the test piece, which has a structure in which the copper foil, the epoxy resin layer, and the prepreg are laminated in this order. In the present disclosure, both of these cases are included in "detachment of the laminate from the prepreg."

The 90-degree peel strength of (i) is preferably 0.65 N/mm or more, 0.7 N/mm or more, 0.75 N/mm or more, or 0.8 N/mm or more. The reduction rate of (ii) is a value obtained by calculating the percentage reduction in the 90-degree peel strength after immersion of the test piece in boiling water for 2 hours based on the 90-degree peel strength of (i) taken as 100%. The reduction rate of (ii) is preferably 19% or less, 18% or less, 17% or less, or 16% or less, and more preferably 15% or less, 14% or less, 13% or less, 12% or less, 11% or less, 10% or less, or 9% or less.

As mentioned above, the surface of the copper foil on the epoxy resin composition layer side of the laminate of the present disclosure preferably has a surface roughness Rzjis of 1.2 μm or less. Copper foils with a small surface roughness Rzjis tend to have poor adhesion to resin substrates, such as prepregs. However, the laminate of the present disclosure is excellent because the adhesion to a resin substrate, such as a prepreg, satisfies the above conditions (i) and (ii).

Furthermore, the laminate of the present disclosure is preferably a laminate in which

$$\text{(iii)}\ X - Y \geq 0.5,$$

with the transmission loss at 40 GHz of a circuit substrate having a characteristic impedance of 50 Ω and a line length of 100 mm taken as XdB/100 mm, the circuit substrate comprising the laminate and a resin substrate (preferably a prepreg) having a dielectric loss tangent at a frequency of 1 GHz at 25°C of 0.016, such that the epoxy resin composition layer of the laminate is in contact with the resin substrate, and

with the transmission loss at 40 GHz of a circuit substrate taken as YdB/100 mm, the circuit substrate comprising the copper foil (i.e., the copper foil used for the laminate according to the present disclosure) and the resin substrate such that the copper foil is in contact with the resin substrate. The (X-Y) value of (iii) reflects the difference in the transmission loss between a circuit substrate comprising the laminate and the resin substrate bonded together and a circuit substrate comprising copper foil having no epoxy resin composition layer and the resin substrate bonded together. The larger the (X-Y) value, the more transmission loss is suppressed by the epoxy resin composition layer; thus, a larger (X-Y) value is preferable. The (X-Y) value is preferably 0.6 or more, 0.7 or more, 0.8 or more, 0.9 or more, or 1.0 or more, and more preferably 1.1 or more, 1.2 or more, 1.3 or more, 1.4 or more, or 1.5 or more.

The circuit substrate for measuring transmission loss is a circuit substrate having a characteristic impedance

of 50 Ω and a line length of 100 mm, as described above. For example, a circuit substrate with a microstrip circuit that has a characteristic impedance of about 50 Ω and a line length of about 100 mm can be prepared by placing two laminates according to the present disclosure on both surfaces of the resin substrate, bonding (curing) them by pressing to form a double-sided copper-clad laminated sheet, and further pattern-etching the copper foil of the double-sided copper-clad laminated sheet. The transmission loss measured in the circuit substrate is S21 (insertion loss).

The laminate of the present disclosure is a laminate that satisfies (i) and (ii) above, and preferably also satisfies (iii) above. Further, the laminate of the present disclosure is more preferably a laminate that can also achieve other effects described above. The laminate of the present disclosure can achieve such desirable effects, in particular, when the epoxy resin composition contains the epoxy resin in an amount of more than 25 parts by mass and less than 125 parts by mass (preferably, for example, 30 to 120 parts by mass) per 100 parts by mass of the acid-modified polyolefin, and contains the epoxy resin and the curing agent in a total amount of about 25 to 75 mass% based on the epoxy resin composition. In other words, the laminate of the present disclosure can be preferably obtained by producing a laminate comprising an epoxy resin composition layer on at least one surface of copper foil using an epoxy resin composition that contains an epoxy resin in an amount of more than 25 parts by mass and less than 125 parts by mass (preferably, for example, 30 to 120 parts by mass) per 100 parts by mass of an acid-modified polyolefin and contains the epoxy resin and a curing agent in a total amount of about 25 to 75 mass% based on the epoxy resin composition; and then confirming whether the effects of (i) and (ii) above are achieved, if necessary (further confirming an effect other than (i) and (ii), such as (iii), if necessary). Thus, in a preferred embodiment, the laminate of the present disclosure is, for example, a laminate comprising copper foil and an epoxy resin composition layer, the epoxy resin composition layer being present on at least one surface of the copper foil, the epoxy resin composition containing an epoxy resin, an acid-modified polyolefin, and a curing agent, the epoxy resin composition containing 30 to 120 parts by mass of the epoxy resin per 100 parts by mass of the acid-modified polyolefin, and containing the epoxy resin and the curing agent in a total amount of 25 to 75 mass% based on the epoxy resin composition.

The laminate of the present disclosure also contributes favorably to the effects of a laminated product comprising the laminate. For example, the laminate of the present disclosure contributes to desirably suppressing transmission loss of a high-frequency signal propagating through wiring while maintaining high peel strength in a copper-clad laminated sheet and a printed circuit board that comprise the laminate of the present disclosure and a substrate. For example, the peel strength can be maintained at 0.6 N/mm or more. Further, preferably, the transmission loss of a circuit substrate composed of copper foil with a resin layer and a resin substrate can be made smaller than the transmission loss of a circuit substrate composed of copper foil with no resin layer and a resin substrate. These correspond to the effects of (i) and (ii), and (iii), respectively, achieved by the epoxy resin composition layer.

Due to such excellent adhesion between copper foil and a substrate, the laminate of the present disclosure can be used, for example, in the production of copper-clad laminated sheets or printed circuit boards to prevent defects such as separation of a circuit, and increase product yield. The laminate of the present disclosure can also achieve a superior reduction in transmission loss in high-frequency applications. Thus, the laminate of the present disclosure can be preferably used, for example, as an insulating layer (to which the epoxy resin composition layer corresponds) and a conductor layer (to which the copper foil corresponds) of a copper-clad laminated sheet or a printed circuit board for high-frequency communication in network equipment.

In the present specification, the term "comprising" includes "consisting essentially of" and "consisting of." Further, the present disclosure includes any combination of the constituent requirements described in the present specification.

In addition, the various characteristics (properties, structures, functions, etc.) described in each embodiment of the present disclosure described above may be combined in any way in specifying the subjects included in the present disclosure. In other words, the present disclosure includes all the subjects comprising all combinations of the combinable characteristics described in the present specification.

## Examples

The embodiments of the present disclosure are more specifically explained below with reference to Examples; however, the embodiments are not limited to the Examples shown below.

### Production Example 1 (Production of Epoxy Resin A)

Allyl glycidyl ether (5.9 g), 0.05 g of 2 mass% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of 1,4-bis(dimethylsilyl)benzene was added dropwise for 15 minutes, and the mixture was then stirred at 90°C for 4 hours. After the toluene was removed by concentration, 10.3 g (epoxy equivalent: 211 g/eq) of 1,4-bis[(2,3-epoxypropyloxypropyl)dimethylsilyl]benzene (epoxy resin A) was obtained as a colorless, transparent liquid.

Production Example 2 (Production of Epoxy Resin B)

1,2-Epoxy-5-hexene (5.0 g), 0.05 g of 2 mass% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of 1,4-bis(dimethylsilyl)benzene was added dropwise for 15 minutes, and the mixture was then stirred at 90°C for 5 hours. After the toluene was removed by concentration, 9.5 g (epoxy equivalent: 195 g/eq) of 1,4-bis[(5,6-epoxyhexyl)dimethylsilyl]benzene (epoxy resin B) was obtained as a colorless, transparent liquid.

Production Example 3 (Production of Epoxy Resin C)

3,4-Epoxy-1-butene (4.0 g), 0.05 g of 2 mass% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of 1,4-bis(dimethylsilyl)benzene was added dropwise for 15 minutes, and the mixture was then stirred at 90°C for 5 hours. After the toluene was removed by concentration, 8.5 g (epoxy equivalent: 167 g/eq) of 1,4-bis[(3,4-epoxybutyl)dimethylsilyl]benzene (epoxy resin C) was obtained as a colorless, transparent liquid.

Production Example 4 (Production of Epoxy Resin D)

1,2-Epoxy-4-vinylcyclohexane (6.4 g), 0.05 g of 2 mass% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of 1,4-bis(dimethylsilyl)benzene was added dropwise for 15 minutes, and the mixture was then stirred at 90°C for 4 hours. After the toluene was removed by concentration, 10.8 g (epoxy equivalent: 221 g/eq) of 1,4-bis{[2-(3,4-epoxycyclohexyl)ethyl] dimethylsilyl}benzene (epoxy resin D) was obtained as a colorless, transparent liquid.

Production Example 5 (Production of Epoxy Resin E)

1,2-Epoxy-4-vinylcyclohexane (4.3 g), 0.05 g of 2 mass% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of bis[(p-dimethylsilyl) phenyl]ether was added dropwise for 15 minutes, and the mixture was then stirred at 90°C for 6 hours. After the toluene was removed by concentration, 8.9 g (epoxy equivalent: 267 g/eq) of 4,4'-bis {[2-(3,4-epoxycyclohexyl)ethyl] dimethylsilyl}diphenyl ether (epoxy resin E) was obtained as a colorless, transparent liquid.

Production Example 6 (Production of Epoxy Resin F)

1,2-Epoxy-4-vinylcyclohexane (7.4 g), 0.05 g of 2 mass% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of 1,3,5-tris(dimethylsilyl)benzene was added dropwise for 15 minutes, and the mixture was then stirred at 90°C for 6 hours. After the toluene was removed by concentration, 11.8 g (epoxy equivalent 208 g/eq) of 1,3,5-tris{[2-(3,4-epoxycyclohexyl)ethyl] dimethylsilyl}benzene (epoxy resin F) was obtained as a colorless, transparent liquid.

Raw Material

The raw materials used in each Example are shown below.

- Acid-modified polyolefin A: special polyolefin resin, Surflen (produced by Mitsubishi Chemical Corporation) (acid value: about 15 mg KOH/g, about 4000 g/eq)
- Acid-modified polyolefin B: hydrogenated styrene thermoplastic elastomer, Tuftec M1913 (produced by Asahi Kasei Corporation, maleic anhydride-modified polyolefin resin (more specifically, hydrogenated SEBS (styrene-ethylene-butylene-styrene copolymer) grafted with a maleic anhydride group), acid value: about 10 mgKOH/g, about 7000 g/eq)
- Epoxy resin G: bisphenol A epoxy resin (Grade 828, produced by Mitsubishi Chemical Corporation) (epoxy equivalent: 189 g/eq)
- Epoxy resin H: dicyclopentadiene epoxy resin (HP-7200, produced by DIC Corporation) (epoxy equivalent: 268 g/eq)
- Epoxy resin I: anthracene epoxy resin (jER YX8800, produced by Mitsubishi Chemical Corporation) (epoxy equivalent: 179 g/eq)

- Epoxy resin J: alicyclic epoxy resin (Celloxide 2021P; general name: 3',4'-epoxycyclohexylmethyl 3,4-epoxycyclohexane carboxylate, produced by Daicel Corporation) (epoxy equivalent: 137 g/eq)
- Curing accelerator A: SAN-AID SI-100L (produced by Sanshin Chemical Industry Co., Ltd.)
- Curing accelerator B: Curezol 2E4MZ (produced by Shikoku Chemicals Corporation)
- Curing agent A: F-a type benzoxazine resin (produced by Shikoku Chemicals Corporation)
- Curing agent B: Rikacid MH-700 (produced by New Japan Chemical Co., Ltd.)
- Curing agent C: EPICLON HPC-8000-65T (produced by DIC Corporation)

Table 1a shows the structural formulas of epoxy resins A to J. Table 1b shows the structural formulas of curing accelerators A and B and curing agents A and B.

Table 1a

| | |
|---|---|
| Epoxy resin A | 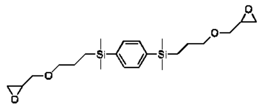 |
| Epoxy resin B | 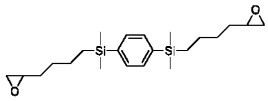 |
| Epoxy resin C | 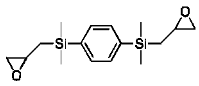 |
| Epoxy resin D | 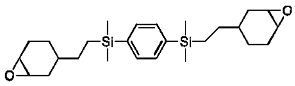 |
| Epoxy resin E | 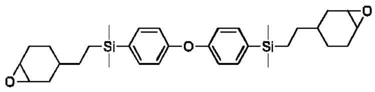 |
| Epoxy resin F | 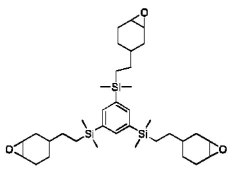 |
| Epoxy resin G | 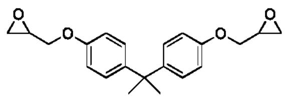 |
| Epoxy resin H | 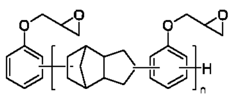 |
| Epoxy resin I | 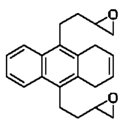 |
| Epoxy resin J | 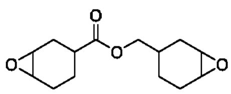 |

Table 1b

| | |
|---|---|
| Curing accelerator A SAN-AID SI-100L | 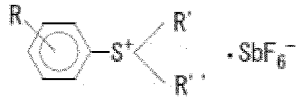 |
| Curing accelerator B Curezol 2E4MZ | 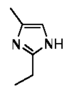 |
| Curing agent A F-a type benzoxazine resin | 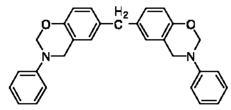 |
| Curing agent B Rikacid MH-700 | 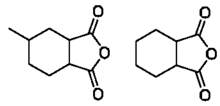 (Mixture) |
| Curing agent C HPC-8000-65T | 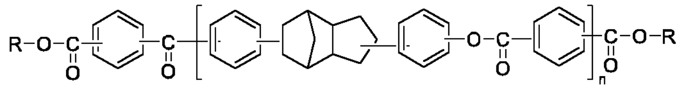 |

Reference Examples 1 to 10

Preparation of Cured Product of Epoxy Resin Alone, and Measurement Of Relative Dielectric Constant and Dielectric Loss Tangent

Each component was weighed to the amount shown in Table 2 (part by mass) and mixed. The obtained epoxy resin compositions were each poured into a resin mold (spacer thickness: 3 mm) and cured by heating in the following order: 1 hour at 60°C, 1 hour at 100°C, 2 hours at 120°C, 2 hours at 150°C, 2 hours at 180°C, and 2 hours at 200°C. The resulting cured products were then cut into pieces having a width of 3 mm, length of 80 mm, and thickness of 1 mm, thus obtaining test pieces for the measurement of dielectric constant.

The relative dielectric constant (10 GHz, 25°C) and dielectric loss tangent (10 GHz, 25°C) of the obtained test pieces were measured using a dielectric constant measurement device (MS46122B network analyzer, produced by AET Inc.). The measured values were regarded as the relative dielectric constant and the dielectric loss tangent of the cured product of the epoxy resin alone. Table 2 also shows these results.

Examples 1 to 20 and Comparison Examples 2 to 10

Preparation of Resin Varnish

Each component was weighed to the amount shown in Table 3 (part by mass). Each weighed component and 2-butanone as an organic solvent were placed into a flask so that the solids concentration (concentration of the epoxy resin composition) was 20 mass%. The mixture was stirred at 60°C to dissolve the epoxy resin composition components in the solvent, thus obtaining a resin varnish.

Production of Epoxy Resin Composition Layer Alone

The resin varnish obtained above was applied to release PET (polyethylene terephthalate) so that the film thickness after drying was 100 μm. The applied resin varnish was heated and dried at 120°C for 5 minutes to achieve a semi-cured (B-stage) state. Additionally, release PET was stacked on the B-stage, and pressing was performed at a pressing temperature of 200°C with a heat holding time of 120 minutes and at a pressure of 2.5 MPa to achieve a cured (C-stage) state. The thus-obtained cured resin layer had a thickness of 100 μm. The release PET was removed from the laminate after pressing, thus obtaining a resin film of the epoxy resin composition layer alone.

Measurement of Relative Dielectric Constant and Dielectric Loss Tangent

In terms of the resin film obtained above, the relative dielectric constant and dielectric loss tangent at a frequency of 10 GHz at 25°C of the epoxy resin composition layer alone were measured according to a cavity resonator perturbation method using a network analyzer.

Production of Laminate (Copper Foil with Resin Layer)

The resin varnish obtained above was applied to the surface of copper foil so that the coating thickness after drying was 5.0 $\mu$m. The applied resin varnish was dried in an oven to achieve a semi-cured (B-stage) state, thus producing a laminate having an epoxy resin composition layer on one surface of the copper foil (copper foil with a resin layer).

Peel Strength (90-Degree Peel Strength Test)

A prepreg (R-1661, produced by Panasonic Corporation) as a resin substrate was stacked on the laminate on the epoxy resin composition layer side, and pressing was performed at a pressing pressure of 2.5 MPa at a pressing temperature of 180°C for 45 minutes, and then at 200°C for 2 hours to obtain a copper-clad laminated sheet with the epoxy resin composition layer in a cured (C-stage) state. The copper-clad laminated sheet can be referred to as a laminate in which the copper foil and prepreg are bonded together, with the epoxy resin composition layer functioning as a primer layer. A masking tape with a width of 0.1 cm was attached to the surface of the copper foil of the copper-clad laminated sheet, followed by etching treatment using a copper etching solution. The masking tape was then peeled off to obtain a 90-degree peel strength test circuit. The obtained circuit was subjected to a 90-degree peel strength test by pulling the copper foil side at 90 degrees relative to the resin substrate at a test rate of 50 mm/min using AGS-X (produced by Shimadzu Corporation).

Peel Strength Reduction Rate after Boiling Test

The 90-degree peel strength test circuit obtained above was immersed in boiling water for 2 hours to obtain a test circuit. The obtained circuit was subjected to the 90-degree peel strength test by pulling the copper foil side at 90 degrees relative to the prepreg at a test rate of 50 mm/min using AGS-X (produced by Shimadzu Corporation). The reduction rate was calculated from the peel strength before and after the boiling test.

Soldering Heat Resistance Test

Two sheets of the copper foil with an epoxy resin composition layer on the resin composition layer side were stacked on both surfaces of a prepreg (R-1661, produced by Panasonic Corporation) used as a substrate, and pressing was performed at a pressing pressure of 2.5 MPa at a pressing temperature of 180°C for 45 minutes, and then at 200°C for 2 hours to obtain a double-sided copper-clad laminated sheet with the epoxy resin composition layers in a cured (C-stage) state. The epoxy resin composition layer functions as a primer layer for bonding with the prepreg in the production of the copper-clad laminated sheet. The obtained copper-clad laminated sheet was used to produce a substrate for evaluation of soldering heat resistance. Specifically, the copper-clad laminated sheet was cut into sample pieces (6.0 cm x 6.0 cm), immersed in a solder bath at 260°C for 30 seconds, and observed in terms of the presence or absence of appearance change, such as swelling. The absence of swelling was evaluated as good, and the presence of swelling was evaluated as poor.

Production of Circuit Substrate

Transmission Loss

Two sheets of the copper foil with an epoxy resin composition layer on the resin layer side were stacked on both surfaces of a prepreg (R-1661, produced by Panasonic Corporation, dielectric loss tangent at a frequency of 1 GHz at 25°C: 0.016) used as a resin substrate, and pressing was performed at a pressing pressure of 2.5 MPa at a pressing temperature of 180°C for 45 minutes, and then at 200°C for 2 hours to obtain a double-sided copper-clad laminated sheet. The copper foil was then subjected to pattern-etching to produce a microstrip circuit having a characteristic impedance of 50 $\Omega$ and a line length of 100 mm. Then, transmission loss S21 (insertion loss) (dB/100 mm) was measured at 25°C, 40 GHz using an E8363B network analyzer.

Table 3 also shows the results.

Table 2

| | | Ref. Ex. 1 | Ref. Ex. 2 | Ref. Ex. 3 | Ref. Ex. 4 | Ref. Ex. 5 | Ref. Ex. 6 | Ref. Ex. 7 | Ref. Ex. 8 | Ref. Ex. 9 | Ref. Ex. 10 |
|---|---|---|---|---|---|---|---|---|---|---|---|
| Cured product of epoxy resin alone | Epoxy resin A | 100.0 | | | | | | | | | |
| | Epoxy resin B | | 100.0 | | | | | | | | |
| | Epoxy resin C | | | 100.0 | | | | | | | |
| | Epoxy resin D | | | | 100.0 | | | | | | |
| | Epoxy resin E | | | | | 100.0 | | | | | |
| | Epoxy resin F | | | | | | 100.0 | | | | |
| | Epoxy resin G | | | | | | | 100.0 | | | |
| | Epoxy resin H | | | | | | | | 100.0 | | |
| | Epoxy resin I | | | | | | | | | 100.0 | |
| | Epoxy resin J | | | | | | | | | | 100.0 |
| | Curing accelerator A | 1.0 | 1.0 | 1.0 | | | | 1.0 | 1.0 | 1.0 | |
| | Curing accelerator B | | | | 2.0 | 2.0 | 2.0 | | | | 2.0 |
| Evaluation | Relative dielectric constant @10 GHz, 25°C | 2.51 | 2.49 | 2.50 | 2.38 | 2.40 | 2.49 | 2.85 | 2.87 | 2.83 | 2.87 |
| | Dielectric loss tangent @10 GHz, 25°C | 0.0085 | 0.0068 | 0.0074 | 0.0061 | 0.0062 | 0.0100 | 0.0296 | 0.0286 | 0.0191 | 0.0393 |

Table 3

| | | | Ex. 1 | Ex. 2 | Ex. 3 | Ex. 4 | Ex. 5 | Ex. 6 | Ex. 7 | Ex. 8 | Ex. 9 | Ex. 10 | Ex. 11 | Ex. 12 | Ex. 13 | Ex. 14 | Ex. 15 | Ex. 16 | Ex. 17 | Ex. 18 | Ex. 19 | Ex. 20 | Comp. Ex. 1 | Comp. Ex. 2 | Comp. Ex. 3 | Comp. Ex. 4 | Comp. Ex. 5 | Comp. Ex. 6 | Comp. Ex. 7 | Comp. Ex. 8 | Comp. Ex. 9 | Comp. Ex. 10 |
|---|---|---|---|---|---|---|---|---|---|---|---|---|---|---|---|---|---|---|---|---|---|---|---|---|---|---|---|---|---|---|---|---|
| Epoxy resin composition | Acid-modified polyolefin | Acid-modified polyolefin A | 100 | 100 | 100 | 100 | 100 | 100 | 100 | 100 | 100 | 100 | 100 | 100 | 100 | 100 | 100 | | | | | | No resin layer (no adhesive layer) | 100 | | 100 | 100 | | | 100 | 100 | 100 |
| | | Acid-modified polyolefin B | | | | | | | | | | | | | | | | 100 | 100 | 100 | 100 | 100 | | | 100 | | | 100 | 100 | | | |
| | Epoxy Resin | Epoxy resin A | 33 | | | | | | | | | | | | | | | | | | | | | | | | | | | | | |
| | | Epoxy resin B | | 32 | | | | | | | | 67 | | | | | | | | | | | | | | | | | | | | |
| | | Epoxy resin C | | | 33 | | | | | | | | | | | | | | | | | | | | | | | | | | | |
| | | Epoxy resin D | | | | 34 | | | | | | | 40 | 33 | 50 | 77 | 118 | 33 | 50 | 77 | 118 | 40 | | | | 6 | 202 | 6 | 200 | | | |
| | | Epoxy resin E | | | | | 37 | | | | | | | | | | | | | | | | | | | | | | | | | |
| | | Epoxy resin F | | | | | | 33 | | | | | | | | | | | | | | | | | | | | | | | | |
| | | Epoxy resin G | | | | | | | 31 | | | | | | | | | | | | | | | | | | | | | | | |
| | | Epoxy resin H | | | | | | | | 36 | | | | | | | | | | | | | | | | | | | | 6 | 217 | |
| | | Epoxy resin I | | | | | | | | | 30 | | | | | | | | | | | | | | | | | | | | | |
| | | Epoxy resin J | | | | | | | | | | | | | | | | | | | | | | | | | | | | | | 10 |
| | Curing agent | Curing agent A | 34 | 35 | 34 | 33 | 30 | 34 | 36 | 31 | 36 | | | | 50 | 75 | 115 | 33 | 50 | 75 | 115 | | | | | 6 | 198 | 6 | 196 | 5 | 182 | 15 |
| | | Curing agent B | | | | | | | | | | | 27 | | | | | | | | | 27 | | | | | | | | | | |
| | | Curing agent C | | | | | | | | | | | | 33 | | | | | | | | | | | | | | | | | | |
| | EP + curing agent concentration (wt%) | | 40 | 40 | 40 | 40 | 40 | 40 | 40 | 40 | 40 | 40 | 40 | 40 | 50 | 60 | 70 | 40 | 50 | 60 | 70 | 40 | - | 0 | 0 | 10 | 80 | 10 | 80 | 10 | 80 | 20 |
| Evaluation for resin composition layer alone | Relative dielectric constant (10 GHz, 25°C) | | 2.33 | 2.31 | 2.33 | 2.31 | 2.30 | 2.33 | 2.45 | 2.39 | 2.38 | 2.29 | 2.29 | 2.28 | 2.35 | 2.45 | 2.62 | 2.33 | 2.30 | 2.31 | 2.35 | 2.27 | - | 2.10 | 2.10 | 2.11 | 2.52 | 2.15 | 2.51 | 2.26 | 2.61 | 2.19 |
| | Dielectric loss tangent (10 GHz, 25°C) | | 0.0048 | 0.0042 | 0.0045 | 0.0042 | 0.0039 | 0.0046 | 0.0079 | 0.0071 | 0.0056 | 0.0041 | 0.0038 | 0.0038 | 0.0049 | 0.0068 | 0.0076 | 0.0045 | 0.0047 | 0.0069 | 0.0079 | 0.0032 | - | 0.0020 | 0.0015 | 0.0013 | 0.0091 | 0.0013 | 0.0092 | 0.0020 | 0.0132 | 0.0019 |
| Evaluation for laminate (copper foil with resin layer) | Peel strength (N/mm) | | 0.87 | 0.86 | 0.88 | 0.85 | 0.81 | 0.87 | 0.91 | 0.82 | 0.90 | 0.85 | 0.82 | 0.81 | 0.95 | 0.88 | 0.82 | 0.99 | 0.93 | 0.82 | 0.80 | 0.99 | 0.86 | 0.76 | 1.59 | 1.21 | 0.41 | 1.22 | 0.35 | 0.95 | 0.46 | 1.10 |
| | Peel strength reduction rate after boiling test (%) | | 8.1 | 7.2 | 5.1 | 8.1 | 7.5 | 8.8 | 15.1 | 10.1 | 9.5 | 4.9 | 5.5 | 6.9 | 5.6 | 6.8 | 8.0 | 8.5 | 0.0 | 9.9 | 15.8 | 8.5 | 16.4 | 22.7 | 55.0 | 20.5 | 1.1 | 28.8 | 2.5 | 25.8 | 8.1 | 21.2 |
| | Soldering Heat Resistance Test | | good | good | good | good | good | good | good | good | good | good | good | good | good | good | good | good | good | good | good | good | good | poor | poor | good | good | good | good | good | good | good |
| Evaluation for circuit substrate | Transmission loss (dB/100 mm) (= X) | | -14.8 | -14.6 | -14.5 | -14.6 | -14.4 | -14.5 | -15.5 | -15.2 | -14.9 | -14.4 | -14.4 | -14.5 | -14.5 | -14.9 | -15.4 | -13.8 | -13.8 | -14.5 | -15.2 | -14.0 | -16.0 | -14.1 | -13.9 | -13.8 | -15.9 | -13.8 | -15.4 | -14.1 | -16.0 | -14.0 |
| | X - Y | | 1.2 | 1.4 | 1.5 | 1.4 | 1.6 | 1.5 | 0.5 | 0.8 | 1.1 | 1.6 | 1.6 | 1.5 | 1.5 | 1.1 | 0.6 | 2.2 | 2.2 | 1.5 | 0.8 | 2.0 | - | 1.9 | 2.1 | 2.2 | 0.1 | 2.2 | 0.6 | 1.9 | 0.0 | 2.0 |

Comparative Example 1 in Table 3 shows the results of measuring the peel strength, solder heat resistance, and transmission loss of the copper foil itself without an epoxy resin composition layer in the same manner as in the laminate comprising an epoxy resin composition layer and copper foil. Since no epoxy resin composition layer was present, the measurement results were obtained in terms of the copper foil bonding directly to the prepreg. Therefore, the value of transmission loss of Comparative Example 1 corresponds to "Y" for use in calculating the value of "X - Y" for evaluation in the bottom row of Table 3. For the other examples (Examples 1 to 20 and Comparative Examples 2 to 10), the value of transmission loss corresponds to "X" for use in calculating the value of "X-Y."

## Claims

1. A laminate comprising copper foil and an epoxy resin composition layer,

   the epoxy resin composition layer being present on at least one surface of the copper foil, the epoxy resin composition layer containing an epoxy resin composition,
   the epoxy resin composition containing an epoxy resin and an acid-modified polyolefin, wherein a test piece composed of the laminate and a prepreg has 90-degree peel strength between the laminate and the prepreg of 0.6 N/mm or more as measured in accordance with JISC6481, and has a reduction rate of the 90-degree peel strength between the laminate and the prepreg of 20% or less after immersion of the test piece in boiling water for 2 hours.

2. The laminate according to claim 1,

   wherein X - Y ≥ 0.5,
   with the transmission loss at 40 GHz of a circuit substrate having a characteristic impedance of 50 Ω and a line length of 100 mm taken as XdB/100 mm, the circuit substrate comprising the laminate and a resin substrate having a dielectric loss tangent at a frequency of 1 GHz at 25°C of 0.016, such that the epoxy resin composition layer of the laminate is in contact with the resin substrate, and
   with the transmission loss at 40 GHz of a circuit substrate taken as YdB/100 mm, the circuit substrate comprising the copper foil and the resin substrate such that the copper foil is in contact with the resin substrate.

3. The laminate according to claim 1 or 2,
   wherein the epoxy resin is an epoxy resin whose cured product has a dielectric loss tangent at a frequency of 10 GHz at 25°C of 0.015 or less and relative dielectric constant at a frequency of 10 GHz at 25°C of 2.8 or less.

4. The laminate according to any one of claims 1 to 3, wherein the epoxy resin is one or more members selected from the group consisting of bisphenol A epoxy resins, biphenyl epoxy resins, dicyclopentadiene epoxy resins, anthracene epoxy resins, and silicon element-containing epoxy resins.

5. The laminate according to any one of claims 1 to 4, wherein the copper foil has a surface roughness Rzjis of 1.2 μm or less on a surface in contact with the epoxy resin composition layer.

6. The laminate according to any one of claims 1 to 5, wherein the epoxy resin composition contains the epoxy resin in an amount of 30 to 120 parts by mass per 100 parts by mass of the acid-modified polyolefin.

7. The laminate according to any one of claims 1 to 6, wherein the epoxy resin composition further contains a curing agent.

8. The laminate according to claim 7, wherein the curing agent is at least one member selected from the group consisting of acid anhydride-based curing agents, benzoxazine-based curing agents, and active ester-based curing agents.

9. The laminate according to any one of claims 1 to 8, wherein the epoxy resin composition contains the epoxy resin and the curing agent in a total amount of 25 to 75 mass% based on the epoxy resin composition.

10. A laminate comprising copper foil and an epoxy resin composition layer,

the epoxy resin composition layer being present on at least one surface of the copper foil,
the epoxy resin composition containing an epoxy resin, an acid-modified polyolefin, and a curing agent,
the epoxy resin composition containing the epoxy resin in an amount of 30 to 120 parts by mass per 100 parts by mass of the acid-modified polyolefin, and containing the epoxy resin and the curing agent in a total amount of 25 to 75 mass% based on the epoxy resin composition.

11. A laminated product comprising the laminate of any one of claims 1 to 10, wherein the epoxy resin composition is a cured product, and the laminated product is a copper-clad laminated sheet or a printed circuit board.

## INTERNATIONAL SEARCH REPORT

International application No.
PCT/JP2021/000147

A. CLASSIFICATION OF SUBJECT MATTER
B32B 15/08(2006.01)i; B32B 15/092(2006.01)i; H05K 1/03(2006.01)i
FI: B32B15/08 J; B32B15/092; H05K1/03 610T; H05K1/03 610L; H05K1/03 630H; H05K1/03 610J
According to International Patent Classification (IPC) or to both national classification and IPC

B. FIELDS SEARCHED
Minimum documentation searched (classification system followed by classification symbols)
B32B15/08; B32B15/092; H05K1/03

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 2018/131571 A1 (SUMITOMO SEIKA CHEMICALS CO., LTD.) 19 July 2018 (2018-07-19) claims, paragraphs [0001]-[0239], examples | 1-11 |
| A | WO 2014/147903 A1 (TOAGOSEI CO., LTD.) 25 September 2014 (2014-09-25) entire text | 1-11 |
| A | WO 2016/185956 A1 (TOYOBO CO., LTD.) 24 November 2016 (2016-11-24) entire text | 1-11 |
| A | WO 2016/017473 A1 (TOAGOSEI CO., LTD.) 04 February 2016 (2016-02-04) entire text | 1-11 |

☐ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 08 March 2021 (08.03.2021) | 16 March 2021 (16.03.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2021/000147

| Patent Documents referred in the Report | Publication Date | Patent Family | Publication Date |
|---|---|---|---|
| WO 2018/131571 A1 | 19 Jul. 2018 | US 2019/0322858 A1 claims, paragraphs [0001]-[0195], examples<br>EP 3569653 A1 claims, paragraphs [0001]-[0148], examples | |
| WO 2014/147903 A1 | 25 Sep. 2014 | (Family: none) | |
| WO 2016/185956 A1 | 24 Nov. 2016 | CN 107109182 A entire text | |
| WO 2016/017473 A1 | 04 Feb. 2016 | US 2017/0259544 A1 entire text<br>CN 106536658 A entire text | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 5118469 B
- JP 6215711 B
- JP 6426290 B
- GB 1123960 B